# EUROPEAN PATENT APPLICATION

(11) **EP 4 766 118 A1**
(43) Date of publication of application: **24.06.2026**
(21) Application number: 25211335.2
(22) Date of filing: 27.10.2025
(51) Int. Cl.: H10K 59/131

(54) **DISPLAY DEVICE**

(30) Priority: 23.12.2024 KR 20240194512
(71) Applicant: LG Display Co., Ltd., Seoul, 07336 (KR)
(72) Inventor: KIM, JiAh, 10845 Gyeonggi-do (KR); YANG, YuCheol, 10845 Gyeonggi-do (KR)
(74) Representative: Ter Meer Steinmeister & Partner

(57) **Abstract**

A display device according to embodiments of the present disclosure may include a substrate including a display area capable of displaying an image and a non-display area outside the display area, and N data lines arranged on the substrate. The substrate may include first to fifth areas sequentially located in a first direction. The display area may include first to fifth display areas included in the first to fifth areas, respectively. The third area may includes a third display area, a first non-display area on one side of the third display area, and a second non-display area on the other side of the third display area. The N data lines may include M1 data lines passing through the first non-display area within the third area, M2 data lines passing through the second non-display area within the third area, and M3 data lines passing through the third display area within the third area. Here, the N is a natural number greater than or equal to 3, and each of the M1, the M2 and the M3 is a natural number greater than or equal to 1, and the sum of the M1, the M2 and the M3 may correspond to the N.

## Description

This application claims priority from Korean Patent Application No. 10-2024-0194512, filed on December 23, 2024.

### TECHNICAL FIELD

Embodiments of the present disclosure relate to a display device.

### BACKGROUND

A display panel of a display device may include a display area where an image is displayed and a non-display area where an image is not displayed. Here, the non-display area may also be referred to as a bezel. The smaller the size of the non-display area of the display panel, the easier it is to increase the size of the display area, implement the display device in various shapes, or apply to various applications. However, it is not easy to reduce the size of the non-display area due to the shape of the display device or the signal lines arranged on the display panel.

### SUMMARY

It is an object to provide a display device capable of implementing a bezel reduction.

It is an object to provide a display device having a data line arrangement structure capable of implementing the bezel reduction and/or capable of improving data driving efficiency.

It is an object to provide a display device having a data line arrangement structure capable of enabling bezel reduction by utilizing a metal layer structure of a display panel.

Embodiments of the present disclosure may provide a display device of a heterogeneous display type having a data line arrangement structure capable of reducing the bezel.

Embodiments of the present disclosure may provide a display device as a wearable device having a data line arrangement structure capable of reducing the bezel. Here, the wearable device may include a virtual reality (VR) device, an augmented reality (AR) device, a mixed reality (MR) device, or an extended reality (XR) device.

The objects of the embodiments of the present disclosure are not limited to the objects described in this specification, and other objects will be clearly understood by those skilled in the art from the description below.

The object is solved by the features of the independent claims preferred embodiments are given in the dependent claims.

In one aspect a display device is provided comprising: a substrate including a display area capable of displaying an image and a non-display area outside the display area; and N data lines arranged on the substrate, wherein the substrate includes at least three areas sequentially located in a first direction, and the display area includes at least three display areas included in the at least three areas, respectively, wherein a middle area between a first area and a last area of the at least three areas includes a middle display area, a first non-display area on one side of the middle display area, and a second non-display area on the other side of the middle display area, wherein the N data lines include M1 data lines passing through the first non-display area, M2 data lines passing through the second non-display area, and M3 data lines passing through the middle display area, and N is a natural number greater than or equal to 3, and each of the M1, the M2 and the M3 is a natural number greater than or equal to 1, and the sum of the M1, the M2 and the M3 corresponds to the N.

In another aspect a display device is provided including a substrate including a display area capable of displaying an image and a non-display area outside the display area, and N data lines arranged on the substrate. The substrate includes first to fifth areas sequentially located in a first direction. The display area includes first to fifth display areas included in the first to fifth areas, respectively. The third area may include a third display area, a first non-display area on one side of the third display area, and a second non-display area on the other side of the third display area.

The N data lines includes M1 data lines passing through the first non-display area within the third area, M2 data lines passing through the second non-display area within the third area, and M3 data lines passing through the third display area within the third area. Here, the N is a natural number greater than or equal to 3, and each of the M1, the M2 and the M3 is a natural number greater than or equal to 1, and the sum of the M1, the M2 and the M3 may correspond to the N.

In another aspect a display device is provided including a substrate including a display area capable of displaying an image and a non-display area outside the display area, and N data lines arranged on the substrate. The substrate includes a first area to a fifth (third) area sequentially located in a first direction, and the display area includes a first display area to a fifth (third) display area included in each of the first area to the fifth (third) area. In the third or middle area of the 5 area or three areas, one edge of the substrate may be curved or dug inwardly.

A first data line among the N data lines may be bent or curved in the other direction in the second display area, and may be bent or curved in one direction in the fourth display area.

In another aspect a display device is provided comprising: a substrate including a display area capable of displaying an image and a non-display area outside the display area; and N data lines arranged on the substrate, wherein the substrate includes a first area to a fifth area sequentially located in a first direction, and the display area includes a first display area to a fifth display area included in each of the first area to the fifth area, wherein, in the third area, one edge of the substrate is dug or curved inward, and wherein a first data line among the N data lines is bent or curved in one direction in the second display area, and is bent or curved in the other direction in the fourth display area.

In the following optional features are provide which can be combined alone or in combination or sub-combination with the aspects mentioned above.

In case there are three areas the middle one has the curved side. In case there are five areas it is the third area being in the middle between the first and second on the one side and the fourth and fifth on the other side.

In one or more embodiment, if one approaches from a second area to the third area, a width of the third area may become narrower.

In one or more embodiment, if a boundary between a fourth area and the third area approaches the center of the third area, the width of the third area may become narrower or if one approaches from the fourth to the third area the width of the third area may become narrower.

In one or more embodiment, one side of the third area may be dug or curved inwardly.

In one or more embodiment, the N data lines may include M1 data lines passing through the first non-display area within the third area, M2 data lines passing through the second non-display area within the third area, and M3 data lines passing through the third display area within the third area. Here, the N may be a natural number greater than or equal to 3, and each of the M1, the M2 and the M3 may be a natural number greater than or equal to 1, and the sum of the M1, the M2 and the M3 may correspond to the N.

In one or more embodiment, as a boundary between a second area and the third area approaches a center of the third area, a width of the third area may become narrower. As a boundary between a fourth area and the third area approaches the center of the third area, the width of the third area may become narrower.

In one or more embodiment, the display device may further comprise a plurality of sub-pixels disposed in the display area.

In one or more embodiment, the third or middle area may include a third or middle display area, a first non-display area on one side of the third display area, and a second non-display area on the other side of the third or middle display area.

The center in first direction of the middle or third area may have the smallest width.

In one or more embodiment, the plurality of sub-pixels may include N1 sub-pixels arranged in the first display area within the first area and connected to a first gate line; N2 sub-pixels arranged in the second display area within the second area and connected to a second gate line; N3 sub-pixels arranged in the third display area within the third area and connected to a third gate line; N4 sub-pixels arranged in the fourth display area within the fourth area and connected to a fourth gate line; and N5 sub-pixels arranged in the fifth display area within the fifth area and connected to a fifth gate line.

In one or more embodiment, among the N1, the 2, the N3, the N4, and the 5, the N3 may be the smallest value, and the N3 is a natural number greater than or equal to 1, wherein each of the N1 and the N5 is equal to the N, and wherein each of the N2 and the N4 may be less than or equal to the N, and the N3 may be less than or equal to the N2 or the N4.

In one or more embodiment, the M1 data lines may include a first data line, wherein the N1 sub-pixels include a first sub-pixel connected to the first data line, wherein the N2 sub-pixels may include a second sub-pixel located in a right diagonal direction from the first sub-pixel and connected to the first data line, wherein the N4 sub-pixels may include a fourth sub-pixel connected to the first data line, wherein the N5 sub-pixels may include a fifth sub-pixel located in a left diagonal direction from the fourth sub-pixel and connected to the first data line.

In one or more embodiment, the first data line may be bent or curved in the second area,

In one or more embodiment, the first data line may be bent or curved in the fourth area.

In one or more embodiment, the first data line may be arranged along an edge of the substrate that is dug or curved inwardly when passing through the first non-display area within the third area.

In one or more embodiment, the first sub-pixel, the second sub-pixel, the fourth sub-pixel, and the fifth sub-pixel may all emit light of a same color.

In one or more embodiment, the M3 data lines may include a second data line to a fourth data line.

In one or more embodiment, the N1 sub-pixels may include a sixth sub-pixel connected to the second data line, wherein the N2 sub-pixel includes a seventh sub-pixel located in a right diagonal direction from the sixth sub-pixel and connected to the second data line, wherein the N3 sub-pixel includes an eighth sub-pixel located in the first direction from the seventh sub-pixel and connected to the second data line, wherein the N4 sub-pixel includes a ninth sub-pixel located in the first direction from the eighth sub-pixel and connected to the second data line, wherein the N5 sub-pixel includes a tenth sub-pixel located in a left diagonal direction from the ninth sub-pixel and connected to the second data line, wherein the second data line may be bent or curved in the second area.

**In** one or more embodiment, the second data line may be bent or curved in the fourth area.

In one or more embodiment, the second data line may pass through the third display area within the third area in the first direction.

**In** one or more embodiment, the sixth sub-pixel, the seventh sub-pixel, the eighth sub-pixel, the ninth sub-pixel, and the tenth sub-pixel may all emit light of a same color.

**In** one or more embodiment, the M2 data lines may include a fifth data line, wherein the N1 sub-pixels include an eleventh sub-pixel connected to the fifth data line, wherein the N5 sub-pixels include a fifteenth sub-pixel connected to the fifth data line.

**In** one or more embodiment, the fifth data line may be arranged along an edge of the substrate when passing through the second non-display area within the third area.

In one or more embodiment, the eleventh sub-pixel and the fifteenth sub-pixel may both emit light of a same color.

In one or more embodiment, the display device may further comprise a plurality of sub-pixels positioned in the plurality of display areas.

In one or more embodiment, the plurality of sub-pixels may include: a plurality of first sub-pixels emitting first color light; a plurality of second sub-pixels emitting second color light; and a plurality of third sub-pixels emitting third color light.

In one or more embodiment, each of the plurality of first sub-pixels may include a first light emitting device including a first pixel electrode and a first sub-pixel circuit connected to the first light emitting device.

In one or more embodiment, each of the plurality of second sub-pixels may include a second light emitting device including a second pixel electrode and a second sub-pixel circuit connected to the second light emitting device.

In one or more embodiment, each of the plurality of third sub-pixels may include a third light emitting device including a third pixel electrode and a third sub-pixel circuit connected to the third light emitting device.

In one or more embodiment, in each of the plurality of first sub-pixels, the first pixel electrode of the first light emitting device may include a first connector for connecting to the first sub-pixel circuit.

In one or more embodiment, in each of the plurality of second sub-pixels, the second pixel electrode of the second light emitting device may include a second connector for connecting to the second sub-pixel circuit.

In one or more embodiment, in each of the plurality of third sub-pixels, the third pixel electrode of the third light emitting device may include a third connector for connecting to the third sub-pixel circuit.

In one or more embodiment, in the second display area and the fourth display area among the first to fifth display areas, at least a part of the plurality of first connectors included in the plurality of first sub-pixels from which the first color light is emitted may be different from the rest in at least one of size, shape, and position, at least a part of the plurality of second connectors included in the plurality of second sub-pixels from which the second color light is emitted may be different from the rest in at least one of size, shape, and position, and at least a part of the plurality of third connectors included in the plurality of third sub-pixels from which the third color light is emitted may be different from the rest in at least one of size, shape, and position.

In one or more embodiment, a first data line among the N data lines may include a first direction line positioned in the second area and extending in the first direction; and a second direction line positioned in the second area and electrically connected to the first direction line to extend in a second direction different from the first direction from the first direction line.

In one or more embodiment, the first direction line may be disposed in a first metal layer, and the second direction line may be disposed in a second metal layer different from the first metal layer.

In one or more embodiment, one of the first metal layer and the second metal layer may be a source-drain metal layer on which a source electrode or a drain electrode of a transistor within the display area is disposed.

In one or more embodiment, the other of the first metal layer and the second metal layer may be a capacitor electrode metal layer on which one of two or more capacitor electrodes constituting a storage capacitor within the display area is disposed.

In one or more embodiment, the display device may further comprise a plurality of power lines arranged within the first metal layer.

In one or more embodiment, at least one power line of the plurality of power lines may be arranged parallel to the first direction line, and/or may intersect and/or overlap with the second direction line.

In one or more embodiment, the at least one power line may have a line width wider than the first direction line.

In one or more embodiment, a first data line among the N data lines may include a first direction line positioned in the fourth area and extending in the first direction; and a second direction line positioned in the fourth area and electrically connected to the first direction line to extend in a second direction different from the first direction from the first direction line.

In one or more embodiment, the first direction line may be disposed in a first metal layer.

In one or more embodiment, the second direction line may disposed in a second metal layer different from the first metal layer.

In one or more embodiment, the display device may be a wearable device in the shape of glasses or a heterogeneous display device and/or may be a wearable device that a user wears on his or her face.

In one or more embodiment, one side of the third area may correspond to a position of a user's nose.

In one or more embodiment, among the two surfaces of the display device, the surface on which an image is displayed may correspond to the opposite surface of aa surface closer to the user wearing the display device.

In one or more embodiment, the third area may include the third display area, a first non-display area on one side of the third display area, and a second non-display area on the other side of the third display area.

In one or more embodiment, the first data line may pass through the first non-display area within the third area.

In one or more embodiment, the third area may include the third display area, a first non-display area on one side of the third display area, and a second non-display area on the other side of the third display area,

In one or more embodiment, the N data lines may include a second data line to a fourth data line.

In one or more embodiment, the second data line may be bent or curved in one direction in the second display area, and may be bent or curved in the other direction in the fourth display area.

In one or more embodiment, the second data line may pass through the first non-display area within the third area.

In one or more embodiment, the third area may include the third display area, a first non-display area on one side of the third display area, and a second non-display area on the other side of the third display area.

In one or more embodiment, a fifth data line among the N data lines may be bent or curved in one direction in the second display area, and may be bent or curved in the other direction in the fourth display area.

In one or more embodiment, the fifth data line may pass through the second non-display area within the third area.

According to embodiments, it is possible to provide a display device having a data line arrangement structure capable of implementing the bezel reduction.

According to embodiments, it is possible to provide a display device capable of increasing data drive efficiency by having a data line arrangement structure that does not require data rendering, thereby implementing the low-power driving.

According to embodiments, it is possible to provide a display device having a data line arrangement structure capable of enabling bezel reduction by utilizing a metal layer structure of a display panel, thereby enabling the process optimization.

According to embodiments, it is possible to provide a display device of a heterogeneous display type having a data line arrangement structure capable of reducing the bezel.

According to embodiments, it is possible to provide a display device as a wearable device having a data line arrangement structure capable of reducing a bezel.

The effects of the embodiments are not limited to the effects described in this specification, and other effects will be clearly understood by those skilled in the art from the description of the claims.

### BRIEF DESCRIPTION OF THE DRAWINGS

The present disclosure will be more fully understood from the detailed description and accompanying drawings provided below, which are provided for illustration purposes only and are not intended to limit the present disclosure. The drawing illustrate in:
FIG. 1 a display device according to embodiments of the present disclosure.
FIG. 2 equivalent circuit for a sub-pixel of a display panel of embodiments.
FIG. 3 an arrangement structure of data lines of a display panel according to embodiments.
FIG. 4 detailed areas included in a waist area of a display panel of embodiments.
FIG. 5 a cross-sectional view of a display panel according of embodiments of the disclosure.
FIG. 6 and FIG. 7 a data line arrangement structure capable of reducing a bezel of a display panel according to embodiments of the present disclosure.
FIG. 8 and FIG. 9 light emission areas of a second display area and light emission areas of a fourth display area in a display panel according to embodiments of the present disclosure.
FIG. 10 and FIG. 11 a line arrangement structure of a second display area and a line arrangement structure of a fourth display area in a display panel according to embodiments of the disclosure.
FIG. 12 and FIG. 13 cross-sectional views of a second display area and a fourth display area in a display panel according to embodiments of the present disclosure.

### DETAILED DESCRIPTION

In the following description of examples or embodiments, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can"

Hereinafter, various embodiments of the disclosure are described in detail with reference to the accompanying drawings.

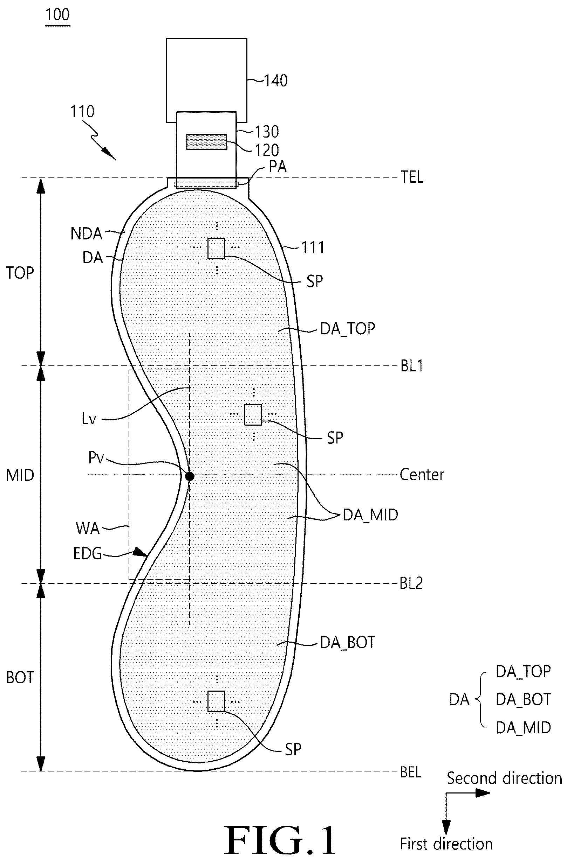

FIG. 1 illustrates a display device 100 of embodiments. Referring to FIG. 1, a display device 100 of embodiments may include a display panel 110 and a driving circuit 120.

The display panel 110 may include a substrate 111 and a plurality of sub-pixels SP formed on the substrate 111.

The display device may include a display area DA capable of displaying an image and a non-display area NDA in which an image is not displayed. The display area DA and the non-display area NDA may be areas of the display panel 110. That is, the display panel 110 may include a display area DA and a non-display area NDA. Here, the non-display area NDA is also referred to as a bezel or may be part of the bezel.

The substrate 111 may be divided into a plurality of areas. For example, the substrate 111 may include an upper area TOP, a lower area BOT, and a middle area MID. The upper area TOP may include a pad area PA. The lower area BOT may be located farthest from the pad area PA among the first to third areas A1, A2 and A3. The middle area MID may be located between the upper area TOP and the lower area BOT.

The display area DA may include an upper display area DA_TOP included in the upper area TOP, a lower display area DA_BOT included in the lower area BOT, and a middle display area DA_MID included in the middle area MID. That is, the substrate 111 may include an upper area TOP including an upper display area DA_TOP, a lower area BOT including a lower display area DA_BOT, and a middle area MID including a middle display area DA_MID. The upper area TOP may include a pad area PA.

The non-display area NDA may be an outer area of the display area DA, and may include a pad area PA that is closer to the upper display area DA_TOP than the middle display area DA_MID.

The substrate 111 may be a flexible substrate.

The substrate 111 may have an upper edge line TEL, a lower edge line BEL, a first boundary line BL1, and a second boundary line BL2.

The upper edge line TEL and the lower edge line BEL may be cut lines of the substrate 111. The upper edge line TEL may be an edge line of the substrate 111 near the pad area PA, and the lower edge line BEL may be an edge line of the substrate 111 opposite to the upper edge line TEL.

The substrate 111 may be bent near the upper edge line TEL. Accordingly, the pad area PA and the components connected thereto (e.g., driving circuit 120, flexible printed circuit board 130, and printed circuit board 140) may be positioned below the substrate 111.

The first boundary line BL1 may be a virtual line indicating a boundary between the upper display area DA_TOP and the middle display area DA_MID, and the second boundary line BL2 may be a virtual line indicating a boundary between the lower display area DA_BOT and the middle display area DA_MID.

A plurality of sub-pixels SP may be arranged in the display area DA. A plurality of sub-pixels SP may be arranged in each of the upper display area DA_TOP, the middle display area DA_MID, and the lower display area DA_BOT.

In the display device 100 of the embodiments, the middle area MID may include a waist area WA that is dug or curved inwardly. So the middle area is smaller in width than the Top and/or bottom area.

Within the middle area MID, the waist area WA may mean an area between a valley line Lv and an edge EDG of the substrate 111. The valley line Lv may be a virtual line that extends in a first direction while passing through a point (Pv, hereinafter referred to as "valley point") where the substrate 111 is dug inwardly most deeply.

For example, as the first boundary line BL1 between the upper display area DA_TOP and the middle display area DA_MID gets closer to the center of the middle display area DA_MID, the width of the middle display area DA_MID may become narrower. In addition, the closer the second boundary line BL2 between the lower display area DA_BOT and the middle display area DA_MID gets to the center of the middle display area DA_MID, the narrower the width of the middle display area DA_MID may become. Here, the width may mean a length in the first direction.

For example, the maximum width of the middle display area DA_MID may be smaller than the maximum width of the upper display area DA_TOP and the maximum width of the lower display area DA_BOT.

In the display device 100 of the embodiments, the driving circuit 120 may be electrically connected to the pad area PA in the non-display area NDA. For example, the driving circuit 120 may be mounted on a flexible printed circuit board 130, and one side of the flexible printed circuit board 130 may be connected to the pad area PA of the substrate 111. Here, the flexible printed circuit board 130 may also be referred to as a flexible printed circuit or a circuit film. A printed circuit board 140 may be connected to the other side of the flexible printed circuit board 130.

The driving circuit 120 may be implemented as an integrated circuit. The driving circuit 120 may include a data driving circuit that supplies a data signal corresponding to an image signal to sub-pixels SP in the display panel 110.

The display device 100 of the embodiments may further include a gate driving circuit that supplies a gate signal to sub-pixels SP in the display panel 110. As an example, the gate driving circuit may be located outside the display panel 110. As another example, the gate driving circuit may be located inside the display panel 110. The gate driving circuit present inside the display panel 110 may be referred to as a gate-in-panel (GIP) type, and may be disposed on the substrate 110. The gate driving circuit present inside the display panel 110 may also be called a gate-in-panel circuit. For example, the gate-in-panel circuit may be placed in a non-display area NDA.

If the gate driving circuit is present outside the display panel 110, the gate driving circuit may be included in the driving circuit 120 or may be present separately from the driving circuit 120.

The display device 100 of the embodiments may further include a controller for controlling the driving circuit 120 and the gate driving circuit. For example, the controller may be mounted on a printed circuit board 140.

The display device 100 of the embodiments may further include a case member covering the non-display area NDA of the display panel 110 and circuit configurations (e.g., a driving circuit 120, a flexible printed circuit board 130, and a printed circuit board 140). For example, the case member may include a wearable member that a user can wear on the face (e.g., a pair of glasses that can be hung on the ears, or a band that can be worn on the head). It may be also called housing or has the function of a housing for accommodating at least parts of display panel 110 and driving circuit elements.

Meanwhile, for example, the display device 100 of the embodiments may have a shape of glasses. For example, the display device 100 of the embodiments may be a heterogeneous display device or a wearable device in the shape of glasses. If the display device 100 of the embodiments is a wearable device in the shape of glasses, the user may wear the display device 100 like glasses. Accordingly, the waist area WA of the display device 100 may correspond to a position of the user's nose, and the upper edge line TEL of the upper area TOP and the lower edge line BEL of the lower area BOT may be adjacent to both ears of the user.

For example, the display device 100 of the embodiments may be at least one wearable device among a virtual reality (VR) device, an augmented reality (AR) device, a mixed reality (MR) device, and an extended reality (XR) device. For example, if the display device 100 is a wearable device that a user wears on his or her face, the surface on which an image is displayed among the two surfaces of the display device 100 may be the opposite surface of the surface that is closer to the user wearing the display device 100. Accordingly, an image displayed on a display device 100 worn by a user can be shown to other users around the wearer. For another example, if the display device 100 is a possible wearable device worn by a user on the face, the surface of the two surfaces of the display device 100 on which an image is displayed may be the surface closer to the user wearing the display device 100. For another example, if the display device 100 is a possible wearable device worn by a user on the face, the surface on which an image is displayed may be both the surface closer to the user wearing the display device 100 and the opposite surface.

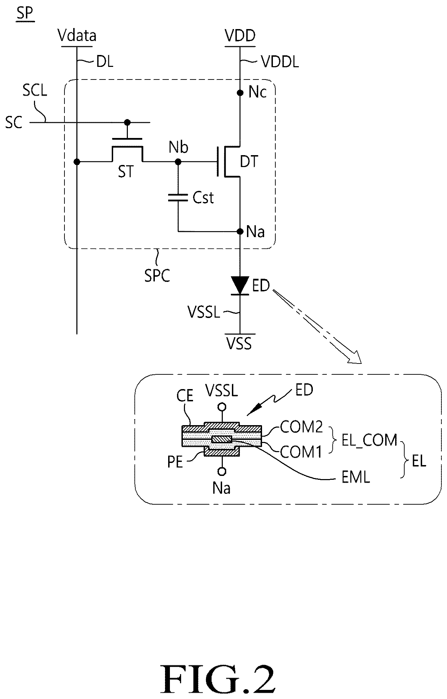

FIG. 2 is an equivalent circuit for a sub-pixel SP of a display panel 110 of embodiments.

Each sub-pixel SP of a display device 100 of embodiments may include a light emitting device ED and a sub-pixel circuit SPC for driving the light emitting device ED.

The light emitting device ED may be an organic light-emitting diode (OLED) based on an organic material, an inorganic light-emitting diode (LED) based on an inorganic material, or a quantum dot light emitting device. However, the disclosure is not limited thereto. For convenience of explanation, it will be exemplified a case where the light emitting device ED is an organic light-emitting diode (OLED).

The sub-pixel circuit SPC may include a plurality of transistors and at least one capacitor for driving the light emitting device ED. The sub-pixel circuit SPC may drive the light emitting device ED by supplying a driving current to the light emitting device ED at a predetermined timing. The light emitting device ED may be driven by the driving current to emit light.

A plurality of transistors included in the sub-pixel circuit SPC may include a driving transistor DT for driving the light emitting device ED and a scan transistor ST that is turned on or off according to a scan signal SC.

The driving transistor DT may supply a driving current to the light emitting device ED. The scan transistor ST may be configured to control an electrical state of a corresponding node within the sub-pixel circuit SPC or to control a state or operation of the driving transistor DT. At least one capacitor may include a storage capacitor Cst for maintaining a constant voltage during a frame.

In order to drive the sub-pixel SP, a data signal Vdata as an image signal, and a scan signal SC as a type of gate signal may be applied to the sub-pixel SP. In addition, in order to drive the sub-pixel SP, a common driving signal including a driving voltage VDD and a base voltage VSS may be applied to the sub-pixel SP.

The light emitting device ED may include a pixel electrode PE, an intermediate layer EL, and a common electrode CE. The intermediate layer EL may be disposed between the pixel electrode PE and the common electrode CE. For example, the pixel electrode PE may be an electrode arranged in each sub-pixel SP, and the common electrode CE may be an electrode commonly arranged in a plurality of sub-pixels SP. For example, the pixel electrode PE may be an anode electrode, and the common electrode CE may be a cathode electrode. In another example, the pixel electrode PE may be a cathode electrode and the common electrode CE may be an anode electrode. In the following, for convenience of explanation, it will be exemplified a case where the pixel electrode PE is an anode electrode and the common electrode CE is a cathode electrode.

If the light emitting device ED is an OLED, the intermediate layer EL may include a emission layer EML, a first common intermediate layer COM1 between the pixel electrode PE and the emission layer EML, and a second common intermediate layer COM2 between the emission layer EML and the common electrode CE. The first common intermediate layer COM1 and the second common intermediate layer COM2 may be collectively referred to as a common intermediate layer EL_COM.

The emission layer EML may be disposed for each sub-pixel SP, or may be disposed commonly across a plurality of sub-pixels SP, and the common intermediate layer EL_COM may be disposed commonly across a plurality of sub-pixels SP, however, is not limited thereto.

The emission layer EML may be arranged in each emission area or may be arranged in common across a plurality of emission areas, and the common intermediate layer EL_COM may be arranged in common across a plurality of emission areas and non-emission areas, however, is not limited thereto.

For example, the first common intermediate layer COM1 may include a hole injection layer HIL, an electron blocking layer EBL, a hole transfer layer HTL, and the like, and the second common intermediate layer COM2 may include an electron transfer layer ETL, a hole blocking layer HBL, and an electron injection layer EIL, however, is not limited thereto. The hole injection layer HIL may inject holes from the pixel electrode PE to the hole transport layer HTL, and the hole transport layer HTL may transport holes to the emission layer EML, and the electron injection layer EIL may inject electrons from the common electrode CE to the electron transport layer ETL, and the electron transport layer ETL may transport electrons to the emission layer EML.

For example, the common electrode CE may be electrically connected to a base voltage line VSSL. A base voltage VSS, which is a type of common voltage, may be applied to the common electrode CE through the base voltage line VSSL. The pixel electrode PE may be electrically connected directly or indirectly (e.g., via another transistor) to a first node Na of the driving transistor DT of each sub-pixel SP. In the present disclosure, the base voltage VSS may also be referred to as a first common voltage, a low-potential power supply voltage, or a low-potential voltage, and the base voltage line VSSL may also be referred to as a first common voltage line, a low-potential power supply voltage line, or a low-potential voltage line.

Each light emitting device ED may be composed of an overlapping portion of a pixel electrode PE, an emission layer EML in an intermediate layer EL, and a common electrode CE. A predetermined light-emission area may be formed by each light emitting device ED. For example, the emission area of each light emitting device ED may include an overlapping area of a pixel electrode PE, an emission layer EML in an intermediate layer EL, and a common electrode CE.

The driving transistor DT may be a driving transistor for supplying a driving current to the light emitting device ED. The driving transistor DT may be connected between a driving voltage line VDDL and the light emitting device ED.

The driving transistor DT may include a first node Na, a second node Nb, and a third node Nc. The first node Na may be electrically connected to the light emitting element ED, the second node Nb may receive a data signal Vdata, and the third node Nc may receive a driving voltage VDD, which is another type of common voltage, from a driving voltage line VDDL. The driving transistor DT may be connected to the first node Na and the third node Nc. In the present disclosure, the driving voltage VDD may also be described as a second common voltage, a high-potential power supply voltage, or a high-potential voltage, and the driving voltage line VDDL may also be described as a second common voltage line, a low-potential power supply voltage line, or a low-potential voltage line.

In the driving transistor DT, the second node Nb may be a gate node, the first node Na may be a source node or a drain node, and the third node Nc may be a drain node or a source node. Hereinafter, for convenience of explanation, in the driving transistor DT, the second node Nb may be a gate node, the first node Na may be a source node, and the third node Nc may be a drain node, however, is not limited thereto.

The scan transistor ST included in the sub-pixel circuit SPC illustrated in FIG. 2 may be a switching transistor for transmitting a data signal Vdata, which is an image signal, to the second node Nb, which is a gate node of the driving transistor DT.

The scan transistor ST may be turned on and off by a scan signal SC, which is a type of gate signal applied through a scan line SCL, which is a type of gate line GL, so as to control the electrical connection between the second node Nb of the driving transistor DT and a data line DL. The drain electrode or the source electrode of the scan transistor ST may be electrically connected to the data line DL, the source electrode or the drain electrode of the scan transistor ST may be electrically connected to the second node Nb of the driving transistor DT, and the gate electrode of the scan transistor ST may be electrically connected to the scan line SCL.

The storage capacitor Cst may be electrically connected between the first node Na and the second node Nb of the driving transistor DT. The storage capacitor Cst may include at least one capacitor electrode electrically connected to the first node Na of the driving transistor DT or corresponding to the first node Na of the driving transistor DT, and at least one capacitor electrode electrically connected to the second node Nb of the driving transistor DT or corresponding to the second node Nb of the driving transistor DT.

The storage capacitor Cst may be an external capacitor intentionally designed outside the driving transistor DT, rather than a parasitic capacitor (e.g., Cgs, Cgd) that may be an internal capacitor between the first node Na and the second node Nb of the driving transistor DT, but, is not limited thereto.

Each of the driving transistor DT and the scan transistor ST may be an n-type transistor or a p-type transistor. However, it is not limited thereto. For example, one of the driving transistor DT and the scan transistor ST may be one of an n-type transistor and a p-type transistor.

The display panel 110 may have a top emission structure or a bottom emission structure. If the display panel 110 has a top emission structure, at least a part of the sub-pixel circuit SPC may overlap with at least a part of the light emitting device ED in the vertical direction. Accordingly, the area of the emission area may be increased and the aperture ratio may be increased. If the display panel 110 has a bottom emission structure, the sub-pixel circuit SPC may not overlap with the light emitting device ED in the vertical direction.

The sub-pixel circuit SPC may have a 2T (Transistor) 1C (Capacitor) structure including two transistors (e.g., DT and ST) and one capacitor Cst as illustrated in FIG. 2, and may further include one or more transistors or one or more capacitors, depending on the case.

Depending on the structure of the sub-pixel circuit SPC, the type and number of gate signal gate lines supplied to the sub-pixel SP may vary. Depending on the structure of the sub-pixel circuit SPC, the type and number of common driving signals supplied to the sub-pixel SP may vary.

Since the circuit elements (e.g., light emitting devices ED implemented as organic light-emitting diodes (OLED) including organic materials) in each sub-pixel SP are vulnerable to external moisture or oxygen, the display panel 110 may further include an encapsulation layer disposed on the light emitting devices ED. The encapsulation layer may prevent external moisture or oxygen from penetrating into the circuit elements (e.g., light emitting devices ED). The encapsulation layer may be configured in various forms so that the light emitting devices ED do not come into contact with moisture or oxygen. For example, the encapsulation layer may be configured with two or more layers in which organic films and inorganic films are alternately laminated. However, the present disclosure is not limited thereto.

The display device 100 may further include a touch sensor layer in which a touch sensor is formed, and a touch sensing circuit that senses the touch sensor formed in the touch sensor layer to determine the presence or absence of a touch or the touch coordinates in order to provide a touch sensing function.

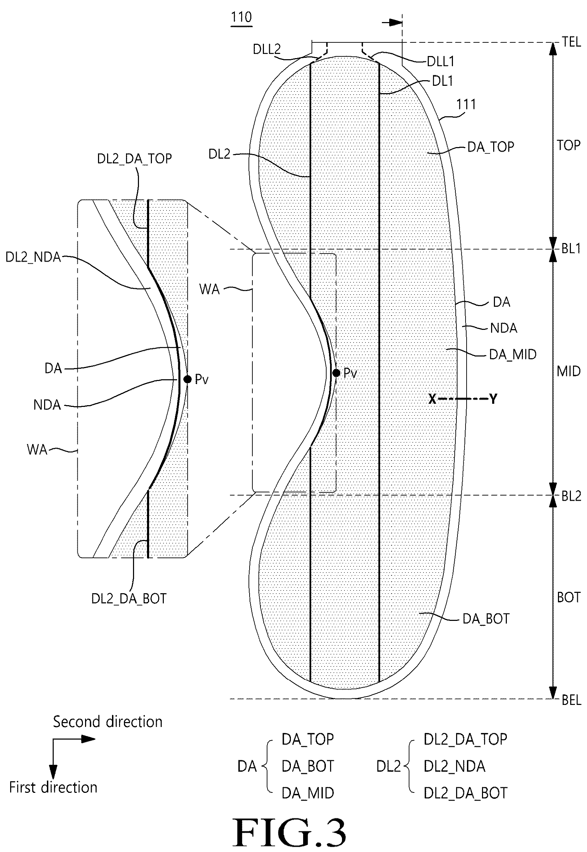

FIG. 3 illustrates the arrangement structure of data lines of the display panel 110 of embodiments. In the following description, FIG. 1 and FIG. 2 are also referred to.

The display panel 110 may include an upper area TOP and a lower area BOT, and a middle area MID between the upper area TOP and the lower area BOT. The upper area TOP may be an area where circuit components (e.g., a driving circuit 120, a flexible printed circuit board 130, and a printed circuit board 140) are connected. The width BTW of a portion corresponding to the upper edge line TEL in the upper area TOP may have a smaller value than other portions.

The display panel 110 may include a plurality of data lines DL for transmitting data signals Vdata to a plurality of sub-pixels SP. The plurality of data lines DL may be arranged in the display area DA.

Depending on the shape (e.g., a glasses shape) of the substrate 111 of the display panel 110, the plurality of data lines DL may include a plurality of first data lines DL1 that do not pass through the waist area WA and a plurality of second data lines DL2 that pass through the waist area WA.

Each of the plurality of first data lines DL1 may be connected to a first data link line DLL1 that extends from the pad area PA through the upper edge line TEL to the upper display area DA_TOP, and may be arranged to extend in a first direction within the upper display area DA_TOP.

Each of the plurality of first data lines DL1 may extend in the first direction in all of the upper display area DA_TOP, the middle display area DA_MID, and the lower display area DA_BOT, and may be arranged without bending.

Each of the plurality of second data lines DL2 may be connected to a second data link line DLL2 that extends from the pad area PA through the upper edge line TEL to the upper display area DA_TOP, and may be arranged while extending in the first direction within the upper display area DA_TOP.

However, each of the plurality of second data lines DL2 may be arranged while bending inwardly so as to be arranged on the substrate 111 that is dug or curved inwardly when passing through the waist area WA within the middle display area DA_MID.

If each of the plurality of second data lines DL2 is bent while passing through the waist area WA, each of the plurality of second data lines may pass through the non-display area NDA included in the waist area WA. Accordingly, each of the plurality of second data lines DL2 may include an upper data line DL2_DA_TOP arranged in the upper display area DA_TOP, a lower data line DL2_DA_BOT arranged in the lower display area DA_BOT, and a bypass data line DL2_NDA that connects the upper data line DL1_DA_TOP and the lower data line DL2_DA_BOT and is arranged in the non-display area NDA.

As described above, each of the plurality of second data lines DL2 may be arranged while bending in the waist area WA, and as the bypass data line DL2_NDA of each of the plurality of second data lines DL2 is arranged in the non-display area NDA, the size of the non-display area NDA included in the waist area WA may increase.

Accordingly, in case that the display device 100 of the embodiments is a wearable device in the shape of glasses, if the size of the non-display area NDA included in the waist area WA increases, the design quality of the display device 100 may decrease, or the display device 100 may become uncomfortable to wear.

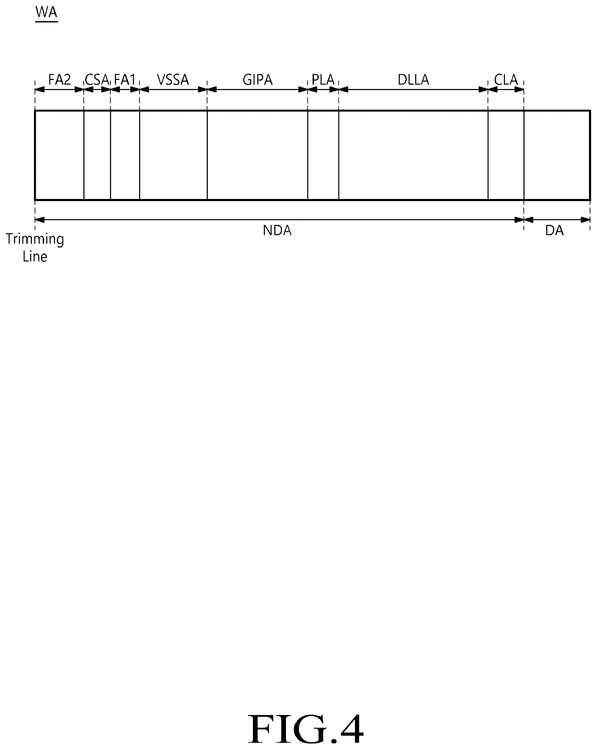

FIG. 4 illustrates detailed areas included in the waist area WA of the display panel 110 of the embodiments.

The non-display area NDA included in the waist area WA may include a data link area DLLA in which a plurality of bypass data lines DL2_NDA of a plurality of second data lines DL2 are arranged, a driving power line area PLA in which driving power lines are arranged, a gate-in-panel circuit area GIPA in which a gate-in-panel circuit, which is a gate driving circuit of a gate-in-panel type, is arranged, a base voltage line area VSSA in which a base voltage line VSSL is arranged, and a crack stopper area CSA in which a crack stopper structure is disposed.

In the driving power line area PLA, gate driving-related link lines connected to the gate-in-panel circuit and driving power lines for transmitting various driving powers (e.g., initialization voltage, reference voltage, etc.) to the sub-pixels SP may be arranged.

The non-display area NDA included in the waist area WA may further include a connection area CLA in which the driving power lines arranged in the driving power line area PLA are extended and gate lines for transmitting gate signals output from the gate-in-panel circuit to the sub-pixels SP are arranged.

The non-display area NDA included in the waist area WA may further include a first free space FA1 between the base voltage line area VSSA and the crack stopper area CSA, and a second free space FA2 between the crack stopper area CSA and a trimming line. Here, the trimming line may correspond to a cutting line of the substrate 111.

As described above, each of the plurality of second data lines DL2 may be arranged while bending in the waist area WA, and since the bypass data line DL2_NDA of each of the plurality of second data lines DL2 may be arranged in the non-display area NDA, so that the non-display area NDA included in the waist area WA may include a large-sized data link area DLLA.

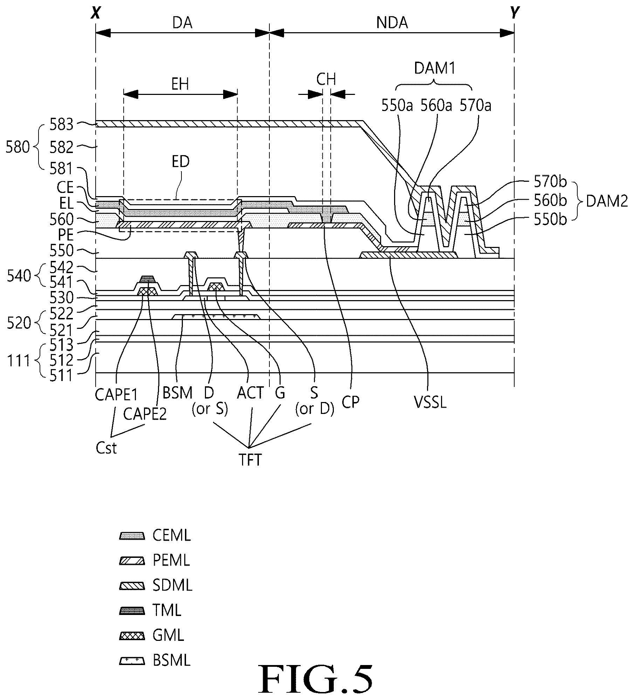

FIG. 5 is a cross-sectional view of a display panel 110 of embodiments. FIG. 5 is a cross-sectional view taken along the X-Y line of FIG. 3.

The display panel 110 of embodiments may include a display area DA and a non-display area NDA. The display panel 110 may include a substrate 111, a buffer layer 520 disposed on the substrate 111, a gate insulating layer 530 disposed on the buffer layer 520, an interlayer insulating layer 540 disposed on the gate insulating layer 530, a planarization layer 550 disposed on the interlayer insulating layer 540, a light emitting device ED disposed on the planarization layer 550 and positioned in the display area DA, and an encapsulation layer 580 disposed on the light emitting device ED.

The substrate 111 may be a single layer or a multilayer. If the substrate 111 is a multilayer, the substrate 111 may include a first substrate 301, an intermediate substrate layer 302, and a second substrate 303. The intermediate substrate layer 302 may be positioned between the first substrate 301 and the second substrate 303. For example, each of the first substrate 301 and the second substrate 303 may be a polyimide (PI) layer, however, is not limited thereto. The intermediate substrate layer 302 may be an inorganic insulating layer, however, is not limited thereto. When a charge is charged on the first substrate 301 which is a polyimide layer, the intermediate substrate layer 302 may block the charge from affecting the transistors arranged on the second substrate 303 through the second substrate 303 which is a polyimide layer.

In addition, the intermediate substrate layer 302 may block moisture components from penetrating upward through the first substrate 301. For example, the intermediate substrate layer 302 may be formed of a single layer of silicon nitride (SiNx) or silicon oxide (SiOx) or a multilayer thereof, and may also be formed of a double layer of silicon dioxide (SiO2) and silicon nitride (SiNx). However, the embodimenhts of the present disclosure are not limited thereto.

The buffer layer 520 may be a single layer or a multilayer, however, is not limited thereto. If the buffer layer 520 is a multilayer, the buffer layer 520 may include a first buffer layer 521 and a second buffer layer 522.

The display panel 110 may further include a transistor TFT and a storage capacitor Cst arranged on the buffer layer 520. The transistor TFT may include an active layer ACT, a gate electrode G, a source electrode S, and a drain electrode D. The storage capacitor Cst may include a first capacitor electrode CAPE1 and a second capacitor electrode CAPE2.

The active layer ACT of the transistor TFT may be disposed on the buffer layer 520, and a gate insulating layer 530 may be disposed on the active layer ACT of the transistor TFT.

The gate electrode G of the transistor TFT may be disposed on the gate insulating layer 530, and may overlap with at least a portion of the active layer ACT.

The interlayer insulating layer 540 may include a first interlayer insulating layer 541 and a second interlayer insulating layer 542. The first interlayer insulating layer 541 may be disposed on the gate electrode G of the transistor TFT. The second interlayer insulating layer 542 may be disposed on the first interlayer insulating layer 541.

The source electrode S and the drain electrode D of the transistor TFT may be disposed on the second interlayer insulating layer 542. The source electrode S of the transistor TFT may be connected to a portion of the active layer ACT through a hole of the second interlayer insulating layer 542 and the first interlayer insulating layer 541, and the drain electrode D of the transistor TFT may be connected to another portion of the active layer ACT of the transistor TFT through another hole of the second interlayer insulating layer 542 and the first interlayer insulating layer 541.

The first capacitor electrode CAPE1 may be disposed on the gate insulating layer 530, and the second capacitor electrode CAPE2 may be disposed on the first interlayer insulating layer 541 and may overlap with the first capacitor electrode CAPE1.

The first capacitor electrode CAPE1 may be disposed in the same metal layer as the gate electrode G of the transistor TFT, and the second capacitor electrode CAPE2 may be disposed between the gate electrode G and the source/drain electrodes of the transistor TFT.

The planarization layer 550 may be disposed on the second interlayer insulating layer 542.

The light emitting element ED may be disposed on the planarization layer 550, and may include a pixel electrode PE, an intermediate layer EL, and a common electrode CE.

The pixel electrode PE may be disposed on the planarization layer 550, and may be electrically connected to a source electrode S or a drain electrode D of a transistor TFT through a hole in the planarization layer 550.

A bank 560 may be disposed on the planarization layer 550 and the pixel electrode PE, and may have an emission hole EH through which a portion of the pixel electrode PE is exposed. The emission hole EH of the bank 560 may correspond to an emission area of the light emitting device ED.

The intermediate layer EL may be disposed on the bank 560, and may be arranged in contact with an upper surface of the pixel electrode PE in the emission hole EH of the bank 560.

The common electrode CE may be disposed on the intermediate layer EL.

The encapsulation layer 580 may be disposed on the common electrode CE. The encapsulation layer 580 may include a first encapsulation layer 581, a second encapsulation layer 582, and a third encapsulation layer 583. The first encapsulating layer 581 and the third encapsulating layer 583 may be inorganic layers, and the second encapsulating layer 582 may be an organic layer.

The display panel 1100 may further include a first dam DAM1 arranged outside the second encapsulation layer 582. For example, the first dam DAM1 may include a plurality of dam configuration layers 550a, 560a and 570a. For example, the plurality of dam configuration layers may include a first dam configuration layer 550a, a second dam configuration layer 560a, and a third dam configuration layer 570a. The first dam configuration layer 550a may include the same organic insulating material as the planarization layer 550, the second dam configuration layer 560a may include the same organic insulating material as the bank 560, and the third dam configuration layer 570a may include the same organic insulating material as a spacer that can be disposed on the bank 560.

The display panel 1100 may further include a second dam DAM2 located outside the first dam DAM1. For example, the second dam DAM2 may include a plurality of dam configuration layers 550a, 560a and 570a, similar to the first dam DAM1.

The first encapsulation layer 581 may be disposed on the common electrode CE, but may extend beyond the first dam DAM1 and the second dam DAM2 to the outside of the second dam DAM2.

The third encapsulation layer 583 may be disposed on the second encapsulation layer 582, but may extend further outside than the second encapsulation layer 582, so as to be extended to the outer periphery of the second dam DAM2 by passing over the upper part of the dam DAM2, together with the first encapsulation layer 581. So, on the DAM1 and DAM2 the second encapsulation layer 582 is non existing and the first encapsulation layer 581 and third encapsulation layer 583 are directly attached to each other and disposed on the DAM1, DAM2 structures.

The display panel 110 may further include a base voltage line VSSL to which a base voltage VSS is applied, and a connection pattern CP that electrically connects the common electrode CE and the base voltage line VSSL.

The base voltage line VSS may be arranged between the second interlayer insulating layer 542 and the planarization layer 550. The base voltage line VSS may be arranged under the planarization layer 550 and may extend to a lower portion of the first dam DAM1.

The connection pattern CP may be disposed between the bank 560 and the planarization layer 550. For example, the connection pattern CP may be located in the non-display area NDA. The connection pattern CP may extend from the upper surface of the planarization layer 550 along the side surface of the planarization layer 550, and may be electrically connected to the base voltage line VSSL.

The bank 560 may further have a connection hole CH. For example, the connection hole CH of the bank 560 may be located in the non-display area NDA.

The common electrode CE may extend from the display area DA to a portion of the non-display area NDA. In the non-display area NDA, the common electrode CE may be electrically connected to an upper surface of the connection pattern CP through the connection hole CH of the bank 560.

The display panel 110 may further include a lower shield metal BSM that overlaps with the active layer ACT of the transistor TFT. The lower shield metal BSM may be disposed between the substrate 111 and the buffer layer 520, or may be disposed between the first buffer layer 521 and the second buffer layer 522.

The display panel 110 may include various metal layers. For example, the display panel 110 may include a lower shield metal layer BSML on which a lower shield metal BSM is disposed, a gate metal layer GML on which a gate electrode G of a transistor TFT and a first capacitor electrode CAPE1 of a storage capacitor Cst are disposed, a capacitor electrode metal layer TML on which a second capacitor electrode CAPE2 of a storage capacitor Cst is disposed, a source-drain metal layer SDML on which a source electrode S and a drain electrode D of a transistor TFT are disposed, a pixel electrode metal layer PEML on which a pixel electrode PE is disposed, and a common electrode metal layer CEML on which a common electrode CE is disposed.

Meanwhile, as described above with reference to FIG. 3 and FIG. 4, due to the shape of the display panel 110, the size of the non-display area NDA included in the waist area WA may increase as data lines (e.g., bypass data lines) to which data signals are applied are arranged in the non-display area NDA. As a result, if the display device 100 of the embodiments is a wearable device in the shape of glasses, the design quality of the display device 100 may deteriorate or the display device 100 may become uncomfortable to wear.

Accordingly, the embodiments may provide a "bezel-reducing data link structure" that can reduce the size of the non-display area NDA included in the waist area WA of the display panel 110. The embodiments may provide a power line structure capable of improving display driving performance. The embodiments may provide a power line structure linked to the bezel-reducing data link structure.

Hereinafter, it will be described a signal structure capable of bezel reduction according to embodiments. However, in the following description, reference will be made to FIGS. 1 to 5 together.

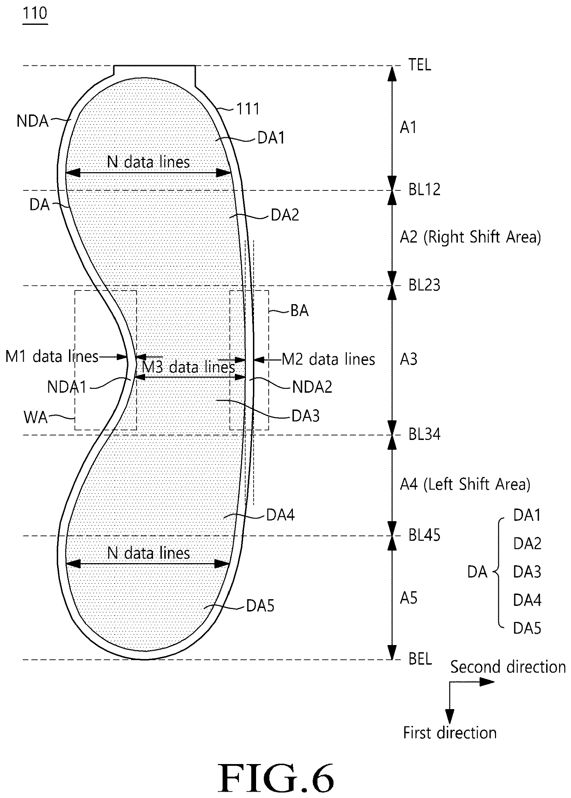

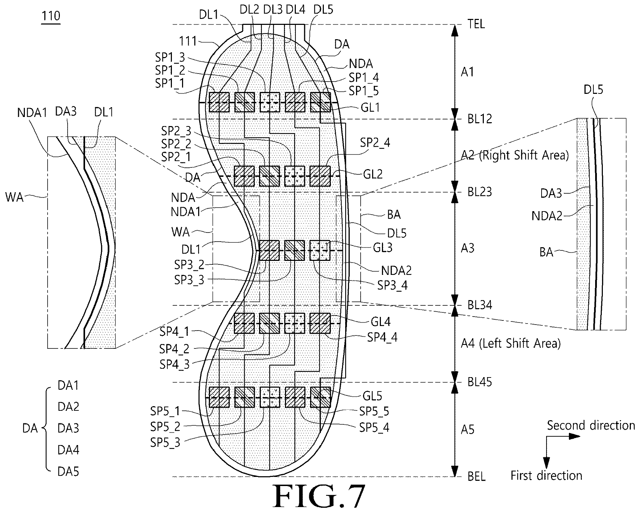

FIGS. 6 and 7 illustrate a data line arrangement structure capable of bezel reduction of a display panel 110 according to embodiments of the disclosure.

Referring to FIGS. 6 and 7, a display panel 110 of embodiments may include a substrate 111 including a display area DA capable of displaying an image and a non-display area NDA outside the display area DA, and N data lines arranged on the substrate 111.

For example, the substrate 111 may include first to fifth areas A1, A2, A3, A4 and A5 sequentially located in a first direction.

For example, the display area DA may include first to fifth display areas DA1, DA2, DA3, DA4 and DA5 which are respectively included in the first to fifth areas A1, A2, A3, A4 and A5. That is, the first area A1 may include the first display area DA1, the second area A2 may include the second display area DA2, the third area A3 may include the third display area DA3, the fourth area A4 may include the fourth display area DA4, and the fifth area A5 may include the fifth display area DA5.

The first to fifth areas A1, A2, A3, A4, A5 may exist between the upper edge line TEL and the lower edge line BEL.

The first area A1 may be an area between the upper edge line TEL and a first boundary line BL12. The first boundary line BL12 may be a boundary between the first area A1 and the second area A2. The first area A1 may be an area including the pad area PA.

The second area A2 may be an area between the first boundary line BL12 and a second boundary line BL23. The second boundary line BL23 may be a boundary between the second area A2 and the third area A3.

The third area A3 may be an area between the second boundary line BL23 and a third boundary line BL34. The third boundary line BL34 may be a boundary between the third area A3 and the fourth area A4.

The fourth area A4 may be an area between the third boundary line BL34 and a fourth boundary line BL45. The fourth boundary line BL45 may be a boundary between the fourth area A4 and the fifth It may be a boundary between the areas A5.

The fifth area A5 may be an area between the fourth boundary line BL45 and the lower edge line BEL.

The third area A3 may include a third display area DA3, a first non-display area NDA1 on one side of the third display area DA3, and a second non-display area NDA2 on the other side of the third display area DA3. The third area A3 may include a waist area WA with one side dug or curved inwardly.

The closer it gets to the center of the third area A3 from the second boundary line BL23 between the second area A2 and the third area A3, the narrower the width of the third area A3. In addition, the closer it gets to the center of the third area A3 from the third boundary line BL34 between the fourth area A4 and the third area A3, the narrower the width of the third area A3.

One side of the third area A3 may include a waist area WA in which the edge line of the substrate 111 is curved or dug inwardly. The other side of the third area A3 may include a back area BA in which the edge line of the substrate 111 is bulged or flat, as opposed to the waist area WA. Even if the other side of the third area A3 may include a back area BA is bulged or flat, its radius is much larger than the radius of the waist area WA.

The waist area WA may include the third display area DA3 and a first non-display area NDA1 in an outer periphery thereof (e.g., a left outer periphery), and the back area BA may include the third display area DA3 and a second non-display area NDA2 in an outer periphery thereof (e.g., a right outer periphery).

Referring to FIG. 6, each of the N data lines may pass through all of the first to fifth areas A1, A2, A3, A4 and A5. Accordingly, N data lines may be arranged in each of the first to fifth areas A1, A2, A3, A4 and A5.

For example, in the first area A1, all N data lines may pass through the first display area DA1. In the fifth area A5, all N data lines may pass through the fifth display area DA5.

As an example, in the second area A2, all N data lines may pass through the second display area DA2. As another example, in the second area A2, some of the N data lines may pass through the second display area DA2, and some of the N data lines may pass through the non-display area NDA on the outside (e.g., the right outside) of the second display area DA2.

As an example, in the fourth area A4, all N data lines may pass through the fourth display area DA4. As another example, in the fourth area A4, some of the N data lines may pass through the fourth display area DA4, and some of the N data lines may pass through a non-display area NDA outside (e.g., right outside) of the fourth display area DA4.

For example, in the third area A3, some of the N data lines (e.g., M3 data lines) may pass through the third display area DA3, some of the N data lines may pass through a first non-display area NDA1 outside (e.g., left outside) of the third display area DA3, and some of the N data lines may pass through a second non-display area NDA2 outside (e.g., right outside) of the third display area DA3.

For example, the N data lines may include M1 data lines passing through the first non-display area NDA1 in the third area A3, M2 data lines passing through the second non-display area NDA2 in the third area A3, and M3 data lines passing through the third display area DA3 in the third area A3.

The M3 data lines may pass through only the third display area DA3 in the third area A3 without passing through the first non-display area NDA1 and the second non-display area NDA2 included in the third area A3.

According to the display panel 110 of the embodiments, N may be the total number of data lines arranged on the display panel 110 and may be a natural number greater than or equal to 3. The M1 may be the total number of data lines passing through the first non-display area NDA1 in the third area A3, and may be a natural number greater than or equal to 1. The M2 may be the total number of data lines passing through the second non-display area NDA2 in the third area A3, and may be a natural number greater than or equal to 1. The M3 may be the total number of data lines passing through only the third display area DA3 among the first non-display area NDA1, the third display area DA3, and the second non-display area NDA2 included in the third area A3, and may be a natural number greater than or equal to 1.

According to the display panel 110 of the embodiments, the sum of M1, M2, and M3 may correspond to N.

Due to the shape of the display device 100 (e.g., a glasses shape), the third area A3 may have a narrower width (e.g., maximum width) than the first, second, fourth, and fifth areas A1, A2, A4 and A5, so that all of the N (i.e., N=M1+M2+M3) data lines cannot be arranged in the third display area DA3 within the third area A3.

For example, due to the shape of the display device 100 (e.g., a glasses shape), only M3 data lines among the N (i.e., N=M1+M2+M3) data lines can pass through the third display area DA3 within the third area A3, and (M1+M2) data lines cannot pass through the third display area DA3 within the third area A3.

In this case, if all of the (M1+M2) data lines that cannot pass through the third display area DA3 in the third area A3 pass through the first non-display area NDA1 in the third area A3, the size of the first non-display area NDA1 should be increased.

However, according to the display device 100, some (e.g., M1 data lines) of the (M1+M2) data lines may pass through the first non-display area NDA1 in the third area A3 and the other some (e.g., M2 data lines) may pass through the second non-display area NDA2 in the third area A3, thereby preventing the size of the first non-display area NDA1 from increasing excessively.

The display panel 110 may further include a plurality of sub-pixels SP arranged in the display area DA. In FIG. 7, it will be described a case in which five data lines DL1, DL2, DL3, DL4 and DL5 are arranged on the display panel 110, a first data line DL1 of the five data lines DL1, DL2, DL3, DL4 and DL5 passes through a first non-display area NDA1 in a third area A3, a fifth data line DL5 of the five data lines DL1, DL2, DL3, DL4 and DL5 passes through a second non-display area NDA2 in a third area A3, and the second to fourth data lines DL2, DL3 and DL4 of the five data lines DL1, DL2, DL3, DL4 and DL5 pass through a third display area DA3 in a third area A3 (i.e., N=5, M1=1, M2=1, and M3=3).

The plurality of sub-pixels SP may include N1 sub-pixels (e.g., SP1_1, SP1_2, SP1_3, SP1_4, SP1_5) arranged in a first display area DA1 in a first area A1 and connected to a first gate line GL1, N2 sub-pixels (e.g., SP2_1, SP2_2, SP2_3, SP2_4) arranged in a second display area DA2 in a second area A2 and connected to a second gate line GL2, N3 sub-pixels (e.g., SP3_2, SP3_3, SP3_4) arranged in a third display area DA3 in a third area A3 and connected to a third gate line GL3, and N4 sub-pixels (e.g., SP4_1, SP4_2, SP4_3, SP3_4) arranged in a fourth display area DA4 in a fourth area A4 and connected to a fourth gate line GL4. SP4_3, SP4_4), and N5 sub-pixels (e.g., SP5_1, SP5_2, SP5_3, SP5_4, SP5_5) arranged in the fifth display area DA5 within the fifth area A5 and connected to a fifth gate line GL5.

In the display panel 110 of the embodiments, among N1, N2, N3, N4, and N5, N3 may be the smallest value. N3 may be a natural number greater than or equal to 1. So in the third display area DA3 the number of pixels is smallest.

According to the display panel 110 of the embodiments , each of N1 and N5 may be equal to N (e.g., N1=N5=N). Each of N2 and N4 may be less than or equal to N (e.g., N2≤N, N4≤N). N3 may be less than or equal to N2 or N4 (e.g., N3≤N2, or N3≤N4).

According to the display panel 110 of the embodiments, N3 may be the same as M3, and (N1-N3) may be (M1+M2).

Referring to FIG. 7, M1 data lines passing through the first non-display area NDA1 in the third area A3 may include a first data line DL1.

N1 sub-pixels may include a first sub-pixel SP1_1 connected to the first data line DL1. N2 sub-pixels may include a second sub-pixel SP2_1 positioned in a right diagonal direction (e.g., a diagonal direction facing downward right) from the first sub-pixel SP1_1, and connected to the first data line DL1. N4 sub-pixels may include a fourth sub-pixel SP4_1 connected to the first data line DL1. N5 sub-pixels may include a fifth sub-pixel SP5_1 positioned in a left diagonal direction (e.g., a diagonal direction facing downward left) from the fourth sub-pixel SP4_1, and connected to the first data line DL1.

Referring to FIG. 6 and FIG. 7, the second area A2 may be a right shift area in which the data transmission path shifts away from the waist area WA in a direction (e.g., rightward in the example of FIG. 6 and FIG. 7). The fourth area A4 may be a left shift area in which the data transmission path shifts toward the waist area WA in a direction (e.g., leftward in the example of FIG. 6 and FIG. 7).

Referring to FIG. 7, the first data line DL1 may be arranged to be bent or curved in the second display area DA2 within the second area A2. The first data line DL1 may be arranged to be bent or curved in the fourth display area DA4 within the fourth area A4. For example, in the third area A3, one edge of the substrate 111 may be dug or curved inward, and the first data line DL1 may be bent or curved in the other direction (for example, toward the right) in the second display area DA2 in the second area A2, and may be bent or curved in one direction (for example, toward the left) in the fourth display area DA4 in the fourth area A4.

The first data line DL1 may be arranged along the edge of the substrate 111 that is dug inwardly when passing through the first non-display area NDA1 in the third area A3.

The first sub-pixel SP1_1, the second sub-pixel SP2_1, the fourth sub-pixel SP4_1, and the fifth sub-pixel SP5_1 may all be connected to the first data line DL1. However, the second and fourth sub-pixels SP2_1 and SP4_1 disposed in the second and fourth display areas DA2 and DA4 may be arranged in different columns from the first and fifth sub-pixels SP1_1 and SP5_1 disposed in the first and fifth display areas DA1 and DA5.

The first sub-pixel SP1_1, the second sub-pixel SP2_1, the fourth sub-pixel SP4_1, and the fifth sub-pixel SP5_1 may all emit light of the same color. As described above, since data signals are sequentially supplied to the sub-pixels emitting light of the same color through the first data line DL1, it is not required a data rendering that requires adjusting data for each color. As a result, data driving efficiency may be improved.

Referring to FIG. 7, the M3 data lines passing through the third display area DA3 in the third area A3 may include second to fourth data lines DL2, DL3, and DL4. Hereinafter, the arrangement structure and the sub-pixel connection structure of the second to fourth data lines DL2, DL3, and DL4 will be representatively described as the arrangement structure and the sub-pixel connection structure of the second data line DL2.

The N1 sub-pixels may include a sixth sub-pixel SP1_2 connected to the second data line DL2. The N2 sub-pixels may include a seventh sub-pixel SP2_2 positioned in the right diagonal direction (e.g., the diagonal direction facing downward to the right) from the sixth sub-pixel SP1_2, and connected to the second data line DL2. The N3 sub-pixels may include an eighth sub-pixel SP3_2 positioned in the first direction from the seventh sub-pixel SP2_2, and connected to the second data line DL2. The N4 sub-pixels may include a ninth sub-pixel SP4_2 positioned in the first direction from the eighth sub-pixel SP3_2, and connected to the second data line DL2. The N5 sub-pixels may include a tenth sub-pixel SP5_2 positioned in the left diagonal direction (e.g., the diagonal direction facing downward to the left) from the ninth sub-pixel SP4_2, and connected to the second data line DL2.

The second data line DL2 may be arranged in an angled, bent or curved manner in the second display area DA2 within the second area A2. The second data line DL2 may be arranged in a bent or curved manner in the fourth display area DA4 within the fourth area A4. For example, in the third area A3, one edge of the substrate 111 is dug inward, and the second data line DL2 may be bent or curved in the other direction (for example, toward the right) in the second display area DA2 in the second area A2, and may be bent or curved in one direction (for example, toward the left) in the fourth display area DA4 in the fourth area A4.

The second data line DL2 may pass through the third display area DA3 in the third area A3 in the first direction.

The sixth sub-pixel SP1_2, the seventh sub-pixel SP2_2, the eighth sub-pixel SP3_2, the ninth sub-pixel SP4_2, and the tenth sub-pixel SP5_2 may all be connected to the second data line DL2. However, the seventh to ninth sub-pixels SP2_2, SP3_2 and SP4_2 arranged in the second to fourth display areas DA2, DA3 and DA4 may be arranged in different columns from the sixth and tenth sub-pixels SP1_2 and SP5_2 arranged in the first and fifth display areas DA1 and DA5.

The sixth sub-pixel SP1_2, the seventh sub-pixel SP2_2, the eighth sub-pixel SP3_2, the ninth sub-pixel SP4_2, and the tenth sub-pixel SP5_2 may all emit light of the same color. As described above, since data signals are sequentially supplied to the sub-pixels emitting light of the same color through the second data line DL2, it is not required a data rendering that requires adjusting data by color. As a result, data driving efficiency may be improved.

Referring to FIG. 7, the M2 data lines passing through the second non-display area NDA2 in the third area A3 may include a fifth data line DL5.

The fifth data line DL5 may be bent or curved in the second display area DA2 in the second area A2, and may be bent or curved in the fourth display area DA4 in the fourth area A4. For example, in the third area A3, one edge of the substrate 111 is dug inward, and the fifth data line DL5 may be bent or curved in the other direction (for example, toward the right) in the second display area DA2 in the second area A2, and may be bent or curved in one direction (for example, toward the left) in the fourth display area DA4 in the fourth area A4.

The N1 sub-pixels may include an eleventh sub-pixel SP1_5 connected to the fifth data line DL5. The N5 sub-pixels may include a fifteenth sub-pixel SP5_5 connected to the fifth data line DL5.

The fifth data line DL5 may be arranged along the edge of the substrate 111 when passing through the second non-display area NDA2 in the third area A3.

The eleventh sub-pixel SP1_5 and the fifteenth sub-pixel SP5_5 may both be connected to the fifth data line DL5.

The eleventh sub-pixel SP1_5 and the fifteenth sub-pixel SP5_5 may both emit the same color light. Since the data signal is sequentially supplied to the sub-pixels SP1_5 and SP5_5 that emit the same color light through the fifth data line DL5, it is not required a data rendering that requires adjusting data for each color, thereby improving the data driving efficiency.

Meanwhile, the first area A1 of FIGS. 6 and 7 may be included in the upper area TOP of FIG. 1, the third area A3 of FIGS. 6 and 7 may be included in the middle area MID of FIG. 1, and the fifth area A5 of FIGS. 6 and 7 may be included in the lower area BOT of FIG. 1.

For example, the second area A2 of FIGS. 6 and 7 may be included in the upper area TOP or the middle area MID of FIG. 1. As another example, a part of the second area A2 of FIGS. 6 and 7 may be included in the upper area TOP of FIG. 1 and another part may be included in the middle area MID of FIG. 1.

For example, the fourth area A4 of FIGS. 6 and 7 may be included in the middle area MID or the bottom area BOT of FIG. 1. As another example, a part of the fourth area A4 of FIGS. 6 and 7 may be included in the middle area MID of FIG. 1 and another part may be included in the bottom area BOT of FIG. 1.

The display device 100 of embodiments may be a wearable device in the shape of glasses or a heterogeneous display device. In this case, when the user wears the display device 100, one side (e.g., corresponding to the waist area WA) of the third area A3 of the display device 100 may correspond to a position of the user's nose.

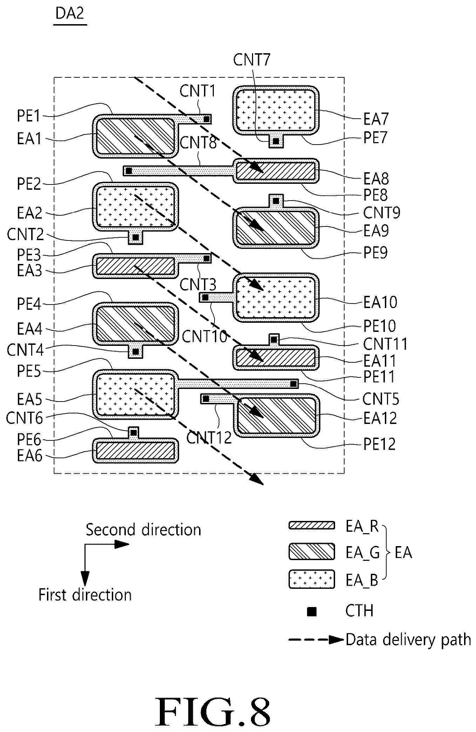

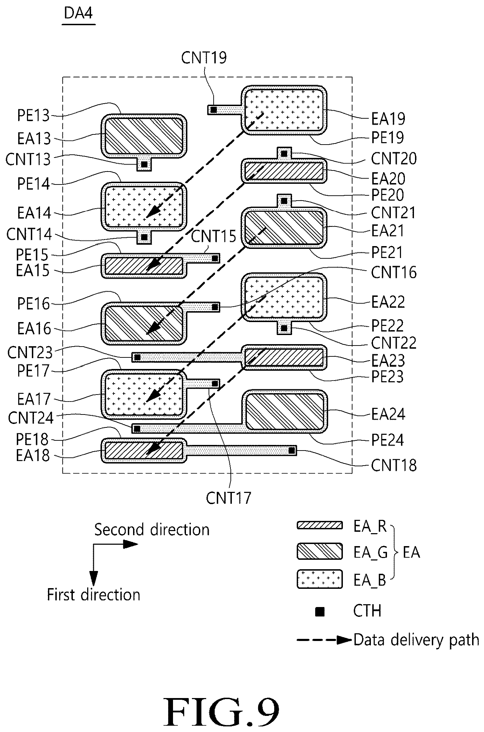

FIG. 8 and FIG. 9 illustrate the emission areas EA1 to EA12 of the second display area DA2 and the emission areas EA13 to EA24 of the fourth display area DA4 in the display panel 110 of embodiments. In the following description, FIG. 2 is also referred to.

Referring to FIG. 8, in the second display area DA2 in the second area A2, each data line may be arranged to be bent or curved in the lower right direction. Depending on the arrangement trajectory of the data lines, a data delivery path may be created in the lower right direction in the second display area DA2 in the second area A2.

Referring to FIG. 9, in the fourth display area DA4 within the fourth area A4, each data line may be arranged to be bent or curved in the lower left direction. Depending on the arrangement trajectory of the data lines, a data delivery path may be created in the lower left direction in the fourth display area DA4 within the fourth area A4.

Depending on the arrangement trajectory of the data lines in each of the second display area DA2 and the fourth display area DA4 described above, the shape of the pixel electrode included in each sub-pixel may vary, and the connection position between the pixel electrode PE included in each sub-pixel SP and the sub-pixel circuit SPC may also vary.

Each of the plurality of sub-pixels SP located in the plurality of display areas DA may include a light emitting device ED and a sub-pixel circuit SPC. The light emitting device ED may include a pixel electrode PE, an intermediate layer EL, and a common electrode CE, and the sub-pixel circuit SPC may be connected to the pixel electrode PE.

The plurality of sub-pixels SP positioned in the plurality of display areas DA may include a plurality of first sub-pixels emitting a first color light, a plurality of second sub-pixels emitting a second color light, and a plurality of third sub-pixels emitting a third color light.

Each of the plurality of first sub-pixels may form an emission area EA_R emitting a first color light, each of the plurality of second sub-pixels may form an emission area EA_G emitting a second color light, and each of the plurality of third sub-pixels may form an emission area EA_B emitting a third color light.

Each of the plurality of first sub-pixels may include a first light emitting device including a first pixel electrode, and a first sub-pixel circuit connected to the first light emitting device. Each of the plurality of second sub-pixels may include a second light emitting device including a second pixel electrode, and a second sub-pixel circuit connected to the second light emitting device.

Referring to FIG. 8, the second display area DA2 may include emission areas EA3, EA6, EA8 and EA11 emitting first color light, emission areas EA1, EA4, EA9 and EA12 emitting second color light, and emission areas EA2, EA5, EA7, and EA10 emitting third color light.

Referring to FIG. 8, in the second display area DA2, each of the plurality of first sub-pixels may include a first light emitting device including a first pixel electrode PE3, PE6, PE8 and PE11, and a first sub-pixel circuit connected to the first light emitting device. Each of the plurality of second sub-pixels may include a second light emitting device including a second pixel electrode PE1, PE4, PE9 and PE12, and a second sub-pixel circuit connected to the second light emitting device. Each of the plurality of third sub-pixels may include a third light emitting device including a third pixel electrode PE2, PE5, PE7 and PE10, and a third sub-pixel circuit connected to the third light emitting device.

Referring to FIG. 9, the fourth display area DA4 may include emission areas EA15, EA18, EA20 and EA23 from which first color light is emitted, emission areas EA13, EA16, EA21 and EA24 from which second color light is emitted, and emission areas EA14, EA17, EA19 and EA22 from which third color light is emitted.

Referring to FIG. 9, in the fourth display area DA4, each of the plurality of first sub-pixels may include a first light emitting device including a first pixel electrode PE15, PE18, PE20 and PE23, and a first sub-pixel circuit connected to the first light emitting device. Each of the plurality of second sub-pixels may include a second light emitting device including a second pixel electrode PE13, PE16, PE21 and PE24, and a second sub-pixel circuit connected to the second light emitting device. Each of the plurality of third sub-pixels may include a third light emitting device including a third pixel electrode PE14, PE17, PE19 and PE22, and a third sub-pixel circuit connected to the third light emitting device.

Referring to FIG. 8 and FIG. 9, in each of the plurality of first sub-pixels from which the first color light is emitted, the first pixel electrode (e.g., PE3, PE6, PE8, PE11; PE15, PE18, PE20, PE23) of the first light emitting device may include first connectors (e.g., CNT3, CNT6, CNT8, CNT11; CNT15, CNT18, CNT20, CNT23), which is a protrusion connected to the first sub-pixel circuit through a contact hole CHT.

In each of the plurality of second sub-pixels from which the second color light is emitted, the second pixel electrodes (e.g., PE1, PE4, PE9, PE12; PE13, PE16, PE21, PE24) of the second light emitting devices may include second connectors (e.g., CNT1, CNT4, CNT9, CNT12; CNT13, CNT16, CNT21, CNT24), which are protrusions connected to the second sub-pixel circuit through the contact hole CHT.

In each of the plurality of third sub-pixels from which third color light is emitted, the third pixel electrode (e.g., PE2, PE5, PE7, PE10; PE14, PE17, PE19, PE22) of the third light emitting device may include third connectors (e.g., CNT2, CNT5, CNT7, CNT10; CNT14, CNT17, CNT19, CNT22), which is a protrusion connected to the third sub-pixel circuit through a contact hole CHT.

Referring to FIGS. 8 and 9, in the second display area DA2 and the fourth display area DA4 among the first to fifth display areas, at least some of the first connectors (e.g., CNT3, CNT6, CNT8, CNT11; CNT15, CNT18, CNT20, CNT23) included in the plurality of first sub-pixels from which first color light is emitted may be different from the rest in at least one of size, shape, and position, at least some of the second connectors (e.g., CNT1, CNT4, CNT9, CNT12; CNT13, CNT16, CNT21, CNT24) included in the plurality of second sub-pixels from which second color light is emitted may be different from the rest in at least one of size, shape, and position, and at least some of the third connectors (e.g., CNT2, CNT5, CNT7, CNT10; CNT14, CNT17, CNT19, CNT22) included in the third sub-pixels from which the third color light is emitted may be different from the rest in at least one of size, shape, and position.

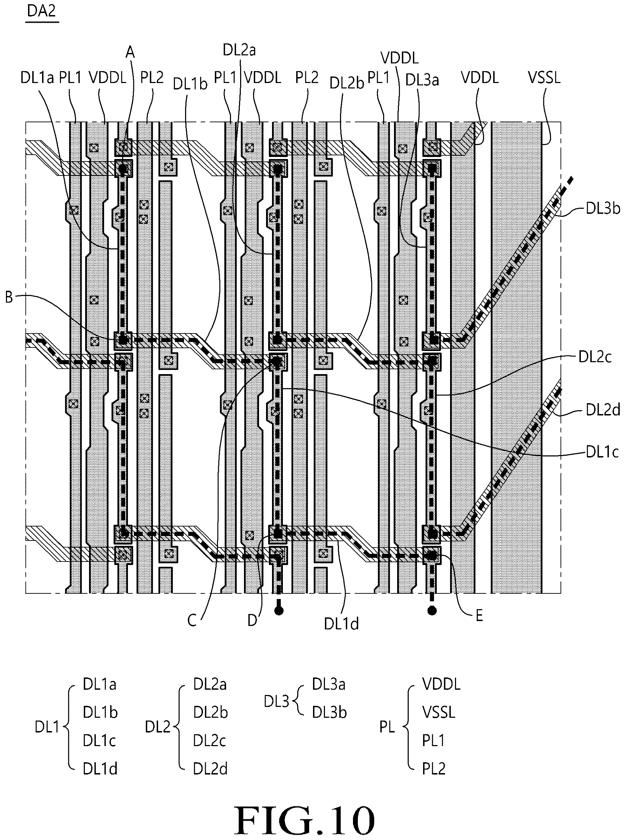

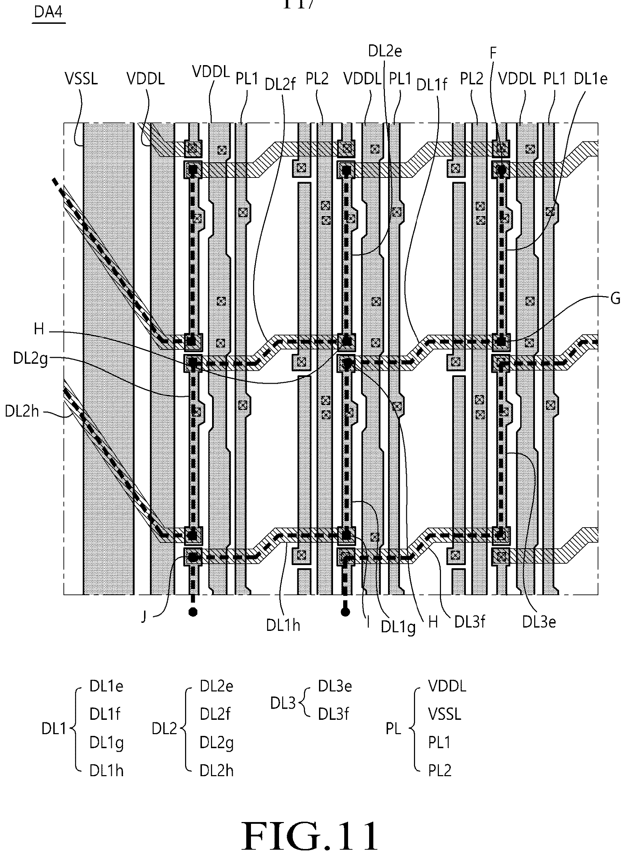

FIGs. 10 and 11 illustrate the line arrangement structure of the second display area DA2 and the line arrangement structure of the fourth display area DA4 in the display panel 110 of embodiments.

Referring to FIG. 10, in the second display area DA2 within the second area A2, each data line DL1, DL2 and DL3 may be arranged to be bent or curved in the lower right direction. Depending on the arrangement trajectory of the data lines DL1, DL2 and DL3, a data delivery path (indicated by a dotted line) may be created in the lower right direction in the second display area DA2 within the second area A2.

Referring to FIG. 11, in the fourth display area DA4 within the fourth area A4, each data line DL1, DL2 and DL3 may be arranged to be bent or curved in the lower left direction. Depending on the arrangement trajectory of these data lines DL1, DL2 and DL3, a data delivery path (indicated by a dotted line) may be created in the lower left direction in the fourth display area DA4 within the fourth area A4.

Referring to FIG. 10, among the N data lines, a first data line DL1 may include a first line part DL1a located in a second area A2 and extending in a first direction, and a second line part DL1b located in a second area A2 and electrically connected to the first line part DL1a and extending in a second direction (e.g., a right horizontal direction) from the first line part DL1a.

Referring to FIG. 10, the first data line DL1 may further include a third line part DL1c located in a second area A2 and electrically connected to the second line part DL1b and extending in a first direction from the second line part DL1b.

Referring to FIG. 10, the first data line DL1 may further include a fourth line part DL1d located in the second area A2 and electrically connected to the third line part DL1c and extending in a second direction (e.g., a right horizontal direction) from the third line part DL1c.

Referring to FIG. 11, the first data line DL1 may further include a fifth line part DL1e located in the fourth area A4 and extending in a first direction (e.g., a vertical direction), and a sixth line part DL1f located in the fourth area A4 and electrically connected to the fifth line part DL1e and extending in a second direction (e.g., a left horizontal direction) from the fifth line part DL1e. Here, the fifth line part DL1e may be electrically connected to the fourth line part DL1d.

Referring to FIG. 11, the first data line DL1 may further include a seventh line part DL1g located in the fourth area A4, electrically connected to the sixth line part DL1f, and extending in the first direction from the sixth line part DL1f.

Referring to FIG. 11, the first data line DL1 may further include an eighth line part DL1h located in the fourth area A4, electrically connected to the seventh line part DL1g, and extending in the first direction from the seventh line part DL1g.

Referring to FIG. 10 and FIG. 11, each of the first, third, fifth, and seventh line parts DL1a, DL1c, DL1e and DL1g of the first data line DL1 may be first-direction lines extending in a first direction (e.g., vertical direction), and each of the second, fourth, sixth, and eighth line parts DL1b, DL1d, DL1f and DL1h of the first data line DL1 may be second-direction lines extending in a second direction (e.g., right horizontal direction).

For example, the first, third, fifth, and seventh line parts DL1a, DL1c, DL1e and DL1g of the first data line DL1 may be first-direction lines, and may be arranged within a first metal layer. The second, fourth, sixth, and eighth line parts DL1b, DL1d, DL1f and DL1h of the first data line DL1 are second-direction lines, and may be arranged in a second metal layer different from the first metal layer.

Referring to FIG. 10, the second data line DL2 among the N data lines may include a first line part DL2a located in the second area A2 and extending in the first direction, and a second line part DL2b located in the second area A2 and electrically connected to the first line part DL2a and extending in the second direction (for example, the right horizontal direction) from the first line part DL2a.

Referring to FIG. 10, the second data line DL2 may further include a third line part DL2c located in the second area A2, electrically connected to the second line part DL2b, and extending in the first direction from the second line part DL2b.

Referring to FIG. 10, the second data line DL2 may further include a fourth line part DL2d located in the second area A2, electrically connected to the third line part DL2c, and extending in the second direction (for example, the right horizontal direction) from the third line part DL2c.

Referring to FIG. 11, the second data line DL2 may further include a fifth line part DL2e located in the fourth area A4 and extending in a first direction (e.g., vertical direction), and a sixth line part DL2f located in the fourth area A4 and electrically connected to the fifth line part DL2e and extending in a second direction (e.g., left horizontal direction) from the fifth line part DL2e. Here, the fifth line part DL2e may be electrically connected to the fourth line part DL2d.

Referring to FIG. 11, the second data line DL2 may further include a seventh line part DL2g located in the fourth area A4, electrically connected to the sixth line part DL2f, and extending in a first direction from the sixth line part DL2f.

Referring to FIG. 11, the second data line DL2 may further include an eighth line part DL2h located in the fourth area A4, electrically connected to the seventh line part DL2g, and extending in the first direction from the seventh line part DL2g.

Referring to FIGS. 10 and 11, each of the first, third, fifth, and seventh line parts DL2a, DL2c, DL2e, and DL2g of the second data line DL2 may be first direction lines that extend in the first direction (e.g., vertical direction), and each of the second, fourth, sixth, and eighth line parts DL2b, DL2d, DL2f and DL2h of the second data line DL2 may be second direction lines that extend in the second direction (e.g., right horizontal direction).

For example, the first, third, fifth, and seventh line parts DL2a, DL2c, DL2e and DL2g of the second data line DL2 are first direction lines, and may be arranged within the first metal layer. The second, fourth, sixth, and eighth line parts DL2b, DL2d, DL2f and DL2h of the second data line DL2 are second direction lines and may be arranged within a second metal layer different from the first metal layer.

Referring to FIG. 10, a third data line DL3 among the N data lines may include a first line part DL3a located in the second area A2 and extending in a first direction, and a second line part DL3b located in the second area A2, electrically connected to the first line part DL3a, and extending in a second direction (e.g., a right horizontal direction) from the first line part DL3a. Referring to FIG. 11, the third data line DL3 may further include a fifth line part DL3e positioned in the fourth area A4 and extending in a first direction (e.g., a vertical direction), and a sixth line part DL3f positioned in the fourth area A4, electrically connected to the fifth line part DL3e, and extending in a second direction (e.g., a left horizontal direction) from the fifth line part DL3e. Here, the fifth line part DL3e may be electrically connected to the second line part DL3b.

Referring to FIG. 10 and FIG. 11, each of the first and fifth line parts DL3a and DL3e of the third data line DL3 may be a first direction line extending in a first direction (e.g., vertical direction), and each of the second and sixth line parts DL3b and DL3f of the third data line DL3 may be a second direction line extending in a second direction (e.g., right horizontal direction).

For example, the first and fifth line parts DL3a and DL3e of the third data line DL3 are first direction lines, and may be arranged within the first metal layer. The second and sixth line parts DL3b and DL3f of the third data line DL3 are second direction lines, and may be arranged within a second metal layer different from the first metal layer.

Referring to FIGS. 10 and 11, the display panel 110 according to the embodiments of the present disclosure may further include a plurality of power lines PL arranged within the first metal layer. For example, the plurality of power lines PL may include a driving voltage line VDDL, a base voltage line VSSL, a first power line PL1, and a second power line PL2. Here, the driving voltage line VDDL may be also referred to as a high-potential voltage line or a first common voltage line, and the base voltage line VSSL may be also referred to as a low-potential voltage line or a second common voltage line. The types of each of the first power line PL1 and the second power line PL2 may vary depending on the structure of the sub-pixel SP. For example, each of the first power line PL1 and the second power line PL2 may be an initialization voltage line for transmitting an initialization voltage to a node in the sub-pixel SP or a reset voltage line for transmitting a reset voltage to a pixel electrode PE in the sub-pixel SP.

At least one of the plurality of power lines PL may be arranged in parallel with line parts corresponding to the first direction lines of the data lines DL1, DL2 and DL3, and may intersect and overlap with line parts corresponding to the second direction lines of the data lines DL1, DL2 and DL3.

At least one power line may have a wider line width than the first direction line of the data lines DL1, DL2 and DL3.

For example, among the first metal layer on which the first direction line is arranged and the second metal layer on which the second direction line is arranged, one may be a source-drain metal layer on which the source electrode or the drain electrode of the transistor in the display area DA is disposed, and the other may be a capacitor electrode metal layer on which one of two or more capacitor electrodes constituting the storage capacitor in the display area DA is disposed.

In this case, as an example, the first metal layer on which the first direction line is arranged may be a source-drain metal layer on which the source electrode or the drain electrode of the transistor in the display area DA is disposed, and the second metal layer on which the second direction line is arranged may be a capacitor electrode metal layer on which one of two or more capacitor electrodes constituting the storage capacitor in the display area DA is disposed. As another example, the first metal layer on which the first direction line is arranged may be a capacitor electrode metal layer on which one of two or more capacitor electrodes constituting the storage capacitor within the display area DA is disposed, and the second metal layer on which the second direction line is arranged may be a source-drain metal layer on which the source electrode or the drain electrode of the transistor within the display area DA is disposed.

As another example, among the first metal layer on which the first direction line is arranged and the second metal layer on which the second direction line is arranged, one may be a source-drain metal layer on which the source electrode or the drain electrode of the transistor within the display area DA is disposed, and the other may be a gate metal layer on which the gate electrode of the transistor within the display area DA is disposed.

In this case, as an example, the first metal layer on which the first direction line is arranged may be a source-drain metal layer on which the source electrode or the drain electrode of the transistor in the display area DA is disposed, and the second metal layer on which the second direction line is arranged may be a gate metal layer on which the gate electrode of the transistor in the display area DA is disposed. As another example, the first metal layer on which the first direction line is arranged may be a gate metal layer on which the gate electrode of the transistor in the display area DA is disposed, and the second metal layer on which the second direction line is arranged may be a source-drain metal layer on which the source electrode or the drain electrode of the transistor in the display area DA is disposed.

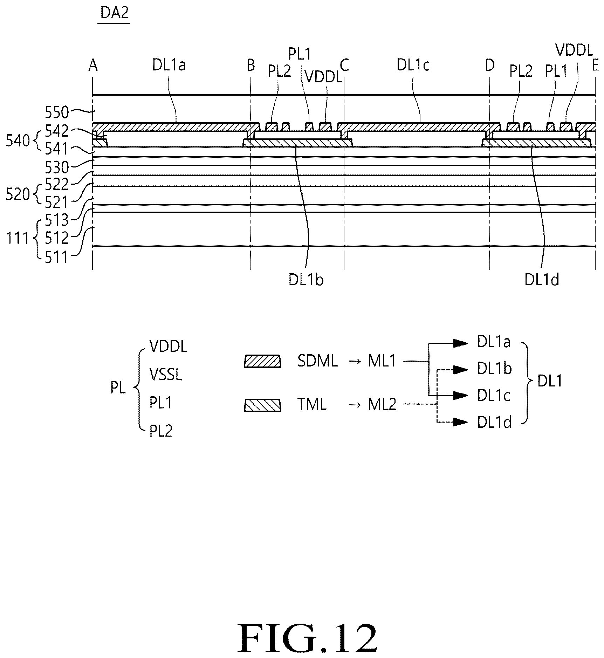

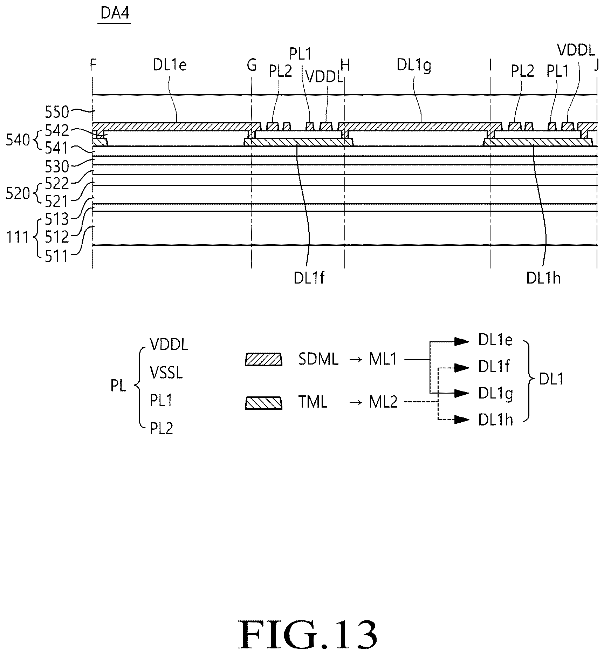

FIG. 12 and FIG. 13 are cross-sectional views of the second display area DA2 and the fourth display area DA4 in the display panel 110 according to embodiments of the present disclosure. However, the stacked structure of the cross-sectional views of FIG. 12 and FIG. 13 is the same as the stacked structure of the cross-sectional view of FIG. 5. Therefore, duplicate descriptions may be omitted.

Referring to FIG. 12, according to the data line arrangement structure according to the embodiments of the present disclosure, in the second display area DA2 in the second area A2, one first data line DL1 may be formed of two metal layers ML1 and ML2.

Referring to FIG. 13, according to the data line arrangement structure according to the embodiments of the present disclosure, in the fourth display area DA4 in the fourth area A4, one first data line DL1 may be also composed of two metal layers. Here, the two metal layers may include a first metal layer ML1 and a second metal layer ML2.

According to the data line arrangement structure according to the embodiments of the present disclosure, in the first display area DA1 in the first area A1, the third display area DA3 in the third area A3, and the fifth display area DA5 in the fifth area A5, one first data line DL1 may be composed of one metal layer. Here, one metal layer may be the first metal layer ML1 or the second metal layer ML2.

Referring to FIG. 12, in the second display area DA2 in the second area A2, the first data line DL1 may include a first line part DL1a, a second line part DL1b, a third line part DL1c, and a fourth line part DL1d.

The first line part DL1a and the third line part DL1c of the first data line DL1 may be first direction lines extending in a first direction (e.g., vertical direction), and the second line part DL1b and the fourth line part DL1d of the first data line DL1 may be second direction lines extending in a second direction (e.g., right horizontal direction).

The first direction lines may be disposed in the first metal layer ML1. The second direction lines may be disposed in the second metal layer ML2. For example, the first metal layer ML1 may be a source-drain metal layer SDML on which a source electrode or a drain electrode of a transistor in the display area DA is disposed, and the second metal layer ML2 may be a capacitor electrode metal layer TML on which one of two or more capacitor electrodes constituting a storage capacitor in the display area DA is disposed.

For example, the source-drain metal layer SDML may be a metal layer disposed between an interlayer insulating layer 540 and a planarization layer 550. The capacitor electrode metal layer TML may be a metal layer disposed between aa first interlayer insulating layer 541 and a second interlayer insulating layer 542.

Referring to FIG. 13, in the fourth display area DA4 within the fourth area A4, the first data line DL1 may include a fifth line part DL1e, a sixth line part DL1f, a seventh line part DL1g, and an eighth line part DL1h.

The fifth line part DL1e and the seventh line part DL1g of the first data line DL1 may be first direction lines extending in a first direction (e.g., vertical direction), and the sixth line part DL1f and the eighth line part DL1h of the first data line DL1 may be second direction lines extending in a second direction (e.g., right horizontal direction).

The first direction lines may be arranged in the first metal layer ML1. The second direction lines may be arranged in the second metal layer ML2. For example, the first metal layer ML1 may be a source-drain metal layer SDML on which a source electrode or a drain electrode of a transistor in the display area DA is disposed, and the second metal layer ML2 may be a capacitor electrode metal layer TML on which one of two or more capacitor electrodes constituting a storage capacitor in the display area DA is disposed.

Referring to FIGS. 12 and 13, a plurality of power lines PL may be arranged within the first metal layer ML1. For example, the plurality of power lines PL may include a driving voltage line VDDL, a base voltage line VSSL, a first power line PL1, and a second power line PL2. Here, the driving voltage line VDDL may be referred to as a high-potential voltage line or a first common voltage line, and the base voltage line VSSL may be referred to as a low-potential voltage line or a second common voltage line. The types of each of the first power line PL1 and the second power line PL2 may vary depending on the structure of the sub-pixel SP. For example, each of the first power line PL1 and the second power line PL2 may be an initialization voltage line for transmitting an initialization voltage to a node within the sub-pixel SP or a reset voltage line for transmitting a reset voltage to a pixel electrode PE within the sub-pixel SP.

Referring to FIG. 12 and FIG. 13, a plurality of power lines PL may be arranged within a first metal layer ML1 together with line parts DL1a, DL1c, DL1e, and DL1g corresponding to the first direction lines of the first data line DL1.

At least one of the plurality of power lines PL may intersect and overlap with line parts DL1b, DL1d, DL1f and DL1h corresponding to the second direction lines of the first data line DL1.

The display panel 110 may further include second metal patterns arranged within a second metal layer ML2 together with line parts (e.g., DL1b, DL1d, DL1f, DL1h) corresponding to the second direction lines of the first data line DL1. The second metal patterns may be disposed in the capacitor electrode metal layer TML as patterns extending in the second direction.

The second metal patterns may intersect and overlap with line parts (e.g., DL1a, DL1c, DL1e, DL1g) corresponding to the first direction lines of the first data line DL1.

In embodiments of the disclosure, as described above, it is possible to provide a display device having a data line arrangement structure capable of implementing the bezel reduction.

In embodiments of the disclosure, it is possible to provide a display device capable of increasing data drive efficiency by having a data line arrangement structure that does not require data rendering, thereby implementing the low-power driving.

In embodiments of the disclosure, it is possible to provide a display device having a data line arrangement structure capable of enabling bezel reduction by utilizing a metal layer structure of a display panel, thereby enabling the process optimization.

In embodiments of the disclosure, it is possible to provide a display device of a heterogeneous display type having a data line arrangement structure capable of reducing the bezel.

In embodiments of the disclosure, it is possible to provide a display device as a wearable device having a data line arrangement structure capable of reducing a bezel.

The above description has been presented to enable any person skilled in the art to make and use the technical idea of the present invention, and has been provided in the context of a particular application and its requirements. Various modifications, additions and substitutions to the described embodiments will be readily apparent to those skilled in the art, and the general principles defined herein may be applied to other embodiments and applications without departing from the spirit and scope of the present invention. The above description and the accompanying drawings provide an example of the technical idea of the present invention for illustrative purposes only. That is, the disclosed embodiments are intended to illustrate the scope of the technical idea of the present invention.

## Claims

1. A display device comprising:
a substrate (111) including a display area (DA) capable of displaying an image and a non-display area (NDA) outside the display area (DA); and
N data lines (DL) arranged on the substrate (111),
wherein the substrate (111) includes at least three areas (A1, A2, A3, A4, A5) sequentially located in a first direction, and the display area (DA) includes at least three display areas (DA1, DA2, DA3, DA4, DA5) included in the at least three areas (A1, A2, A3, A4, A5), respectively,
wherein a middle area (A3) among the at least three areas (A1, A2, A3, A4, A5) includes a middle display area (DA3) among the at least three display areas (DA1, DA2, DA3, DA4, DA5), a first non-display area (NDA1) on one side of the middle display area (DA3), and a second non-display area (NDA2) on the other side of the middle display area (DA3),
wherein the N data lines (DL) include M1 data lines passing through the first non-display area (NDA1), M2 data lines passing through the second non-display area (NDA2), and M3 data lines passing through the middle display area (DA3), and
wherein the N is a natural number greater than or equal to 3, and each of the M1, the M2 and the M3 is a natural number greater than or equal to 1, and the sum of the M1, the M2 and the M3 corresponds to the N.

2. The display device of claim 1, wherein a width of the middle area (A3) becomes narrower if one approaches from a first or second area (A1, A2) to the middle area (A3), and the width of the middle area (A3) becomes narrower, if one approaches from a fifth or fourth area (A5, A4) to the middle area (A3).

3. The display device of claim 1 or 2, in the middle area (A3), one edge of the substrate (111) is dug or curved inward.

4. The display device of any one of the preceding claims, wherein the substrate (111) includes at a first to fifth areas (A1, A2, A3, A4, A5) sequentially located in a first direction, and the display area (DA) includes a first to fifth display areas (DA1, DA2, DA3, DA4, DA5) included in the first to fifth areas (A1, A2, A3, A4, A5), respectively,
wherein a first data line (DL1) among the N data lines (DL) is bent or curved in one direction in the second display area (DA2), and/or is bent or curved in the other direction in the fourth display area (DA4).

5. The display device of any one of the preceding claims, further comprising a plurality of sub-pixels (SP) disposed in the display area (DA), wherein the plurality of sub-pixels (SP) include:
N1 sub-pixels (SP1_1, SP1_2, SP1_3, SP1_4, SP1_5) arranged in the first display area (DA1) within the first area (A1) and connected to a first gate line (GL1);
N2 sub-pixels (SP2_1, SP2_2, SP2_3, SP2_4) arranged in the second display area (DA2) within the second area (A2) and connected to a second gate line (GL2);
N3 sub-pixels (SP3_2, SP3_3, SP3_4) arranged in the third display area (DA3) within the third area (A3) and connected to a third gate line (GL3);
N4 sub-pixels (SP4_1, SP4_2, SP4_3, SP4_4) arranged in the fourth display area (DA4) within the fourth area (A4) and connected to a fourth gate line (GL4); and
N5 sub-pixels (SP5_1, SP5_2, SP5_3, SP5_4, SP5_5) arranged in the fifth display area (DA5) within the fifth area (A5) and connected to a fifth gate line (GL5),
wherein, among the N1, the N2, the N3, the N4, and the N5, the N3 is the smallest value, and the N3 is a natural number greater than or equal to 1,
wherein each of the N1 and the N5 is equal to the N, and
wherein each of the N2 and the N4 is less than or equal to the N, and the N3 is less than or equal to the N2 or the N4.

6. The display device of claim 5, wherein the M1 data lines include a first data line (DL1),
wherein the N1 sub-pixels (SP1_1, SP1_2, SP1_3, SP1_4, SP1_5) include a first sub-pixel (SP1_1) connected to the first data line (DL1),
wherein the N2 sub-pixels (SP2_1, SP2_2, SP2_3, SP2_4) include a second sub-pixel (SP2_1) located in a right diagonal direction from the first sub-pixel (SP1_1) and connected to the first data line (DL1),
wherein the N4 sub-pixels (SP4_1, SP4_2, SP4_3, SP4_4) include a fourth sub-pixel (SP4_1) connected to the first data line (DL1),
wherein the N5 sub-pixels (SP5_1, SP5_2, SP5_3, SP5_4, SP5_5) include a fifth sub-pixel (SP5_1) located in a left diagonal direction from the fourth sub-pixel (SP4_1) and connected to the first data line (DL1),
wherein the first data line (DL1) is bent or curved in the second area (DA2) and in the fourth area (DA4), and
wherein the first data line (DL1) is arranged along an edge of the substrate (111) that is dug or curved inwardly when passing through the first non-display area (NDA1) within the third or middle area (DA3),
preferably the first sub-pixel (SP1_1), the second sub-pixel (SP2_1), the fourth sub-pixel (SP4_1), and the fifth sub-pixel (SP5_1) all emit light of a same color.

7. The display device of claim 5 or 6, wherein the M3 data lines (DL2, DL3, DL4) include a second data line to a fourth data line (DL2, DL3, DL4),
wherein the N1 sub-pixels (SP1_1, SP1_2, SP1_3, SP1_4, SP1_5) include a sixth sub-pixel (SP1_2) connected to the second data line (DL2),
wherein the N2 sub-pixel (SP2_1, SP2_2, SP2_3, SP2_4) includes a seventh sub-pixel (SP2_2) located in a right diagonal direction from the sixth sub-pixel (SP1_2) and connected to the second data line (DL2),
wherein the N3 sub-pixel (SP3_2, SP3_3, SP3_3) includes an eighth sub-pixel (SP3_2) located in the first direction from the seventh sub-pixel (SP2_2) and connected to the second data line (DL2),
wherein the N4 sub-pixel (SP4_1, SP4_2, SP4_3, SP4_4) includes a ninth sub-pixel (SP4_2) located in the first direction from the eighth sub-pixel (SP3_2) and connected to the second data line (DL2),
wherein the N5 sub-pixel (SP5_1, SP5_2, SP5_3, SP5_4, SP5_5) includes a tenth sub-pixel (SP5_2) located in a left diagonal direction from the ninth sub-pixel (SP4_2) and connected to the second data line (DL2),
wherein the second data line (DL2) is bent or curved in the second area (A2) and in the fourth area (A4), and passes through the third display area (DA3) within the third area (A3) in the first direction,
preferably the sixth sub-pixel (SP1_2), the seventh sub-pixel (SP2_2), the eighth sub-pixel (SP3_2), the ninth sub-pixel (SP4_2), and the tenth sub-pixel (SP5_2) all emit light of a same color.

8. The display device of claim 5, 6 or 7, wherein the M2 data lines include a fifth data line (DL5),
wherein the N1 sub-pixels (SP1_1, SP1_2, SP1_3, SP1_4, SP1_5) include an eleventh sub-pixel (SP1_5) connected to the fifth data line (DL5),
wherein the N5 sub-pixels (SP5_1, SP5_2, SP5_3, SP5_4, SP5_5) include a fifteenth sub-pixel (SP5_5) connected to the fifth data line (DL5), and
wherein the fifth data line (DL5) is arranged along an edge of the substrate (111) when passing through the second non-display area (NDA2) within the third area (A3),
preferably the eleventh sub-pixel (SP1_5) and the fifteenth sub-pixel (SP5_5) both emit light of a same color.

9. The display device of any one of the preceding claims, further comprising a plurality of sub-pixels positioned in the plurality of display areas (DA1, DA2, DA3, DA4, DA5), wherein the plurality of sub-pixels include:
a plurality of first sub-pixels (SP1_1, SP1_4, SP2_1, SP2_4, SP3_2, SP4_1, SP4_4, SP5_1, SP5_4) emitting first color light;
a plurality of second sub-pixels pixels (SP1_2, SP1_5, SP2_2, SP3_3, SP4_2, SP5_2, SP5_5) emitting second color light; and
a plurality of third sub-pixels pixels (SP1_3, SP2_3, SP3_4, SP4_3, SP5_3) emitting third color light,
wherein each of the plurality of first sub-pixels pixels (SP1_1, SP1_4, SP2_1, SP2_4, SP3_2, SP4_1, SP4_4, SP5_1, SP5_4) includes a first light emitting device including a first pixel electrode and a first sub-pixel circuit connected to the first light emitting device,
wherein each of the plurality of second sub-pixels (SP1_2, SP1_5, SP2_2, SP3_3, SP4_2, SP5_2, SP5_5) includes a second light emitting device including a second pixel electrode and a second sub-pixel circuit connected to the second light emitting device,
wherein each of the plurality of third sub-pixels (SP1_3, SP2_3, SP3_4, SP4_3, SP5_3) includes a third light emitting device including a third pixel electrode and a third sub-pixel circuit connected to the third light emitting device,
wherein, in each of the plurality of first sub-pixels (SP1_1, SP1_4, SP2_1, SP2_4, SP3_2, SP4_1, SP4_4, SP5_1, SP5_4), the first pixel electrode of the first light emitting device includes a first connector (CNT3, CNT6, CNT8, CNT11; CNT15, CNT18, CNT20, CNT23) for connecting to the first sub-pixel circuit,
wherein, in each of the plurality of second sub-pixels (SP1_2, SP1_5, SP2_2, SP3_3, SP4_2, SP5_2, SP5_5), the second pixel electrode of the second light emitting device includes a second connector (CNT1, CNT4, CNT9, CNT12; CNT13, CNT16, CNT21, CNT24) for connecting to the second sub-pixel circuit,
wherein, in each of the plurality of third sub-pixels (SP1_3, SP2_3, SP3_4, SP4_3, SP5_3), the third pixel electrode of the third light emitting device includes a third connector (CNT2, CNT5, CNT7, CNT10; CNT14, CNT17, CNT19, CNT22) for connecting to the third sub-pixel circuit, and
wherein, in the second display area (DA2) and the fourth display area (DA4) at least a part of the plurality of first connectors (CNT3, CNT6, CNT8, CNT11; CNT15, CNT18, CNT20, CNT23) are different from the rest in at least one of size, shape, and position,
at least a part of the plurality of second connectors (CNT1, CNT4, CNT9, CNT12; CNT13, CNT16, CNT21, CNT24) are different from the rest in at least one of size, shape, and position, and
at least a part of the plurality of third connectors (CNT2, CNT5, CNT7, CNT10; CNT14, CNT17, CNT19, CNT22) are different from the rest in at least one of size, shape, and position.

10. The display device of any one of the preceding claims, wherein a first data line (DL1) among the N data lines includes:
a first direction line (DL1a, DL1c) positioned in the second area (A2) and extending in the first direction; and
a second direction line (DL1b, DL1d) positioned in the second area (A2) and electrically connected to the first direction line (DL1a, DL1c) to extend in a second direction different from the first direction from the first direction line (DL1a, DL1c),
preferably the first direction line (DL1a, DL1c) is disposed in a first metal layer, and the second direction line (DL1b, DL1d) is disposed in a second metal layer different from the first metal layer.

11. The display device of claim 10, wherein one of the first metal layer and the second metal layer is a source-drain metal layer on which a source electrode or a drain electrode of a transistor within the display area is disposed, and
wherein the other of the first metal layer and the second metal layer is a capacitor electrode metal layer on which one of two or more capacitor electrodes constituting a storage capacitor within the display area is disposed.

12. The display device of claim 11, further comprising a plurality of power lines (VDDL, VSSL, PL1, PL2) arranged within the first metal layer, wherein at least one power line (VDDL, VSSL, PL1, PL2) of the plurality of power lines is arranged parallel to the first direction line (DL1a, DL1c), and intersects and overlaps with the second direction line (DL1b, DL1d), preferably.

13. The display device of claim 12, wherein the at least one power line (VSSL) has a line width wider than the first direction line (DL1a, DL1c).

14. The display device of any one of the preceding claims, wherein a first data line (DL1) among the N data lines includes:
a first direction line (DL1e, DL1g) positioned in the fourth area (A4) and extending in the first direction; and
a second direction line (DL1f, DL1h) positioned in the fourth area (A4) and electrically connected to the first direction line (DL1e, DL1g) to extend in a second direction different from the first direction from the first direction line (DL1e, DL1g),
preferably the first direction line (DL1e, DL1g) is disposed in a first metal layer, and the second direction line (DL1f, DL1h) is disposed in a second metal layer different from the first metal layer.

15. The display device of any one of the preceding claims, wherein the display device is a wearable device in the shape of glasses or a heterogeneous display device, and one side of the third area (A3) corresponds to a position of a user's nose.
